# EUROPÄISCHE PATENTSCHRIFT

(11) **EP 3 622 208 B1**
(45) Veröffentlichungstag und Bekanntmachung des Hinweises auf die Patenterteilung: **28.06.2023**
(21) Anmeldenummer: 18725126.9
(22) Anmeldetag: 03.05.2018
(51) Int. Cl.: F16K 31/08, F16K 37/00, F16K 31/06, H02K 41/03, H02K 11/215, G01D 5/20, B01L 3/02

(54) **VERFAHREN ZUM BERÜHRUNGSLOSEN BESTIMMEN DER POSITION EINES ANGETRIEBENEN LÄUFERS EINES ELEKTROMOTORS, ELEKTROMOTOR, UND PIPETTIERSYSTEM ZUM ASPIRIEREN UND DISPENSIEREN VON PIPETTIERFLÜSSIGKEIT MIT EINEM SOLCHEN ELEKTROMOTOR**
METHOD FOR CONTACTLESS DETERMINATION OF THE POSITION OF AN ARMATURE OF AN ELECTRIC MOTOR, ELECTRIC MOTOR, AND PIPETTING SYSTEM FOR ASPIRING AND DISPERSING PIPETTING LIQUID WITH SUCH ELECTRIC MOTOR
PROCÉDÉ DE DÉTERMINATION SANS CONTACT DE LA POSITION D'UN ARMATURE D'UN MOTEUR ÉLECTRIQUE, MOTEUR ÉLECTRIQUE ET SYSTÈME DE TUYAUTERIE POUR ASPIRER ET DISPERSER UN LIQUIDE DE TUYAUTERIE AVEC UN TEL MOTEUR ÉLECTRIQUE

(30) Priorität: 12.05.2017 DE 102017110388
(43) Veröffentlichungstag der Anmeldung: 18.03.2020
(73) Patentinhaber: Hamilton Bonaduz AG, 7402 Bonaduz (CH)
(72) Erfinder: ETTINGER, Reto, 8610 Uster (CH); RAST, Jürg, 8753 Mollis (CH); GYSEL, Fridolin, 8134 Adliswil (CH)
(74) Vertreter: Schmitt-Nilson Schraud Waibel Wohlfrom Patentanwälte Partnerschaft mbB
(86) Internationale Anmeldenummer: PCT/EP2018/061403
(87) Internationale Veröffentlichungsnummer: WO 2018/206404

(56) Entgegenhaltungen:
- EP-A1- 2 169 356
- EP-A2- 1 978 633
- WO-A1-2017/017084
- WO-A1-2017/017084
- DE-A1- 4 141 000
- DE-A1-102008 060 840
- DE-U1-202010 003 659
- US-A1- 2015 022 030

## Beschreibung

Die vorliegende Erfindung ist auf dem Gebiet von Elektromotoren. Insbesondere betrifft die vorliegende Erfindung das Bestimmen der Position eines Läufers eines Elektromotors. Weiter insbesondere ist die vorliegende Erfindung auf dem Gebiet von durch Elektromotoren angetriebenen Pipettiersystemen.

US 2015/0022030 A1 offenbart einen Linearmotor, welcher einen Stator mit einer Längsachse und einer Armatur umfasst, die relativ zum Stator zwischen zwei Endpositionen in Richtung der Längsachse beweglich ist. Entweder hat der Stator oder die Armatur erregbare elektrische Spulen und die Armatur oder der Stator wird durch ein permanentes Magnetfeld angeregt, das in Richtung der Längsachse periodisch ist. Der Linearmotor umfasst ferner ein Positionserfassungssystem zum Erfassen der Position der Armatur relativ zum Stator. Das Positionserfassungssystem ist ein berührungsloses Betriebspositionserfassungssystem, das dazu ausgelegt ist, ein Signal zu erzeugen, das dem Abstand zwischen einem Referenzort am Stator und einer Referenzstelle an der Armatur entspricht.

DE 41 41 000 A1 betrifft Anordnungen und Verfahren zur Positionsbestimmung, wobei eine Testgröße oder -struktur, welche sich linear oder umfangsmäßig erstreckt und sich ggf. periodisch wiederholt, einen sinus- oder sinusoidförmigen Verlauf besitzt und auf mindestens drei Sensoren gleichzeitig einwirkt. Das Ausgangssignal der Sensoren wird vektoriell oder über eine Integraltransformation zusammengefasst und ergibt eine Positionsinformation.

WO 2017/017084 A1 offenbart eine Pipettiervorrichtung zum Pipettieren von Dosierflüssigkeiten, mit einem sich längs einer Kanalbahn erstreckenden Pipettierkanal, in dem ein als Festkörper ausgebildeter Kolben längs der Kanalbahn beweglich aufgenommen ist, um durch Bewegung längs der Kanalbahn den Druck eines Arbeitsgases, das den Kolben an einer der Dosierflüssigkeit zugewandten Dosierseite benetzt, zu verändern.

DE 10 2008 060840 A1 offenbart ein Verfahren, welches das Lesen eines Messsignals, das eine Bewegung eines Elektromotors beschreibt, und das Bestimmen von Nullstellen des Messsignals umfasst. Ein sinusförmiges Signal wird durch eine Fourier-Transformation an die Nullstellen angepasst.

Pipettiersysteme sind ein Beispiel für technische Systeme, bei denen ein bewegliches Element, oft ein beweglicher Kolben, mit großer Präzision bewegt wird. In einem Pipettiersystem wird durch die Bewegung des Kolbens Pipettierflüssigkeit durch eine Pipettierspitze aspiriert bzw. dispensiert. Für viele Anwendungen, insbesondere im Bereich der Laborautomation, muss das Abgeben bzw. Aufnehmen von Flüssigkeit, d.h. die Dispensation und die Aspiration von Flüssigkeit, sehr genau erfolgen. Daraus ergibt sich das generelle Bestreben, möglichst exakte Bewegungen mit dem Kolben auszuführen. Bei Antrieb des Kolbens mit einem Elektromotor sind somit exakte Bewegungen des Läufers des Elektromotors wünschenswert. Im Stand der Technik gibt es Ansätze, die Position des Kolbens in einem Pipettiersystem zu bestimmen und den Elektromotor dementsprechend anzusteuern. Allerdings sind solche bisherigen Systeme mit Positionsbestimmung nicht zufriedenstellend. Auch in vielen anderen technischen Gebieten gibt es technische Systeme, bei denen eine durch einen Elektromotor angetriebene Komponente exakt bewegt werden soll.

Demzufolge wäre es wünschenswert, ein verbessertes Verfahren zur Positionsbestimmung, einen verbesserten Elektromotor und ein verbessertes Pipettiersystem bereitzustellen.

Die Erfindung ist definiert durch ein Verfahren zum berührungslosen Bestimmen der Position eines angetriebenen Läufers eines Elektromotors gemäß Anspruch 1, einen Elektromotor mit berührungsloser Positionsbestimmung gemäß Anspruch 9, ein Pipettiersystem gemäß Anspruch 13 und ein Computerprogramm gemäß Anspruch 14. Weitere Ausführungsformen sind in den abhängigen Ansprüchen gegeben.

Beispielhafte Ausführungsformen der Erfindung ermöglichen eine direkte und effiziente Positionsbestimmung des Läufers des Elektromotors, d.h. eine Positionsbestimmung direkt an der Quelle der Bewegung. Durch das berührungslose Bestimmen der Position des Läufers wirkt keine zusätzliche Last in Form einer zusätzlichen angetriebenen Masse auf den Elektromotor. Im Vergleich zu bisherigen Ansätzen, bei denen der Läufer des Elektromotors oder eine nachgelagerte angetriebene Komponente einen Sensor mechanisch betätigt, kann das berührungslose Bestimmen der Position eine größere Dynamik unterstützen, die Abnutzung der Komponenten verhindern und das Gesamtsystem robuster machen.

Das Verfahren kann die ohnehin für das Antreiben des Läufers vorhandenen Permanentmagnete für die berührungslose Positionsbestimmung des Läufers nutzen. Dabei wird die Tatsache genutzt, dass das von den Permanentmagneten erzeugte Magnetfeld nicht nur als Grundlage für die Bewegung des Läufers verwendet wird, sondern auch messbar entlang der Bewegungsbahn des Läufers vorhanden ist. Das von den Permanentmagneten erzeugte Magnetfeld bildet die Grundlage für die Positionsbestimmung des Läufers. Es ist aber auch möglich, dass rein für die Positionsbestimmung vorgesehene, zu den Antriebsmagneten zusätzliche Permanentmagnete vorhanden sind, deren Magnetfeld gemessen und für die Positionsbestimmung verwendet wird. In diesem Fall sind die zusätzlichen Permanentmagnete auch antriebsfest mit dem Läufer verbunden, und die Magnetfeld-Sensoren sind entlang der Bewegungsbahn der zusätzlichen Permanentmagnete angeordnet.

Die Mehrzahl von Permanentmagneten sind so im Läufer angeordnet, dass sich ein Läufermagnetfeld mit einer Mehrzahl von periodisch beabstandeten Maxima ausbildet. Der Begriff Läufermagnetfeld bezeichnet dabei das in dem Referenzsystem des Läufers vorhandene und in diesem System durch die feste Anordnung der Permanentmagnete statische Magnetfeld. Die Maxima sind lokale Maxima, d.h. im Vergleich zu der direkten Umgebung lokale magnetische Süd- bzw. Nordpole. Der Begriff periodisch beabstandete Maxima macht deutlich, dass das Läufermagnetfeld alternierende Süd- und Nordpole hat, deren Abfolge und Abstand sich zumindest für einen Teil des Läufermagnetfelds wiederholen. Somit erzeugen die Permanentmagnete ein Läufermagnetfeld mit alternierenden Süd- und Nordpolen und mit einer starken oszillierenden Komponente. Das Läufermagnetfeld erzeugt in dem Referenzsystem des Stators ein Momentanmagnetfeld, wobei die momentane Ausbildung dieses Magnetfelds von der Position des Läufers abhängig ist. Dadurch dass das Läufermagnetfeld eine Mehrzahl von periodisch beabstandeten Maxima hat, hat das durch die Mehrzahl von Permanentmagneten erzeugte, an der Mehrzahl von Magnetfeld-Sensoren anliegende Momentanmagnetfeld eine starke Signalkomponente mit derjenigen Ortsfrequenz, die dem Abstand benachbarter gleichartiger Maxima des Läufermagnetfelds entspricht. Diese Signalkomponente wird hierin die spezifische spektrale Signalkomponente genannt, welche mittels der von den Magnetfeld-Sensoren bestimmten Messwerten bestimmt wird. Über diese spezifische spektrale Signalkomponente wird die Position des angetriebenen Läufers auf effiziente Weise bestimmt. Das Vorhandensein einer starken periodischen Komponente in dem durch die Permanentmagnete erzeugten Magnetfeld und das gezielte Bestimmen der spezifischen spektralen Signalkomponente mit dieser Ortsfrequenz ermöglicht eine direkte und effiziente Positionsbestimmung des Läufers des Elektromotors.

Das Verfahren ist sowohl auf Linearmotoren als auch auf Elektromotoren mit einem sich drehenden Rotor als auch auf jegliche andere Arten von Elektromotoren anwendbar. In einem Linearmotor hat der Läufer eine lineare Bewegungsbahn. Die Bewegungsbahn eines Rotors kann durch die Summe aller Punkte beschrieben werden, die eine bestimmte Komponente des Rotors, z. B. eine dem Luftspalt benachbarte Komponente, während des Betriebs abläuft. Demzufolge kann die Bewegungsbahn des Läufers in einem Elektromotor mit sich drehendem Rotor als eine Kreisbahn beschrieben werden. Die Anordnung der Magnetfeldsensoren entlang der Bewegungsbahn des Läufers kann derart sein, dass die Anordnung die gleiche geometrische Grundstruktur, also z.B. eine lineare bzw. kreisförmige Anordnung, hat, aber die Anordnung bezüglich der Bewegungsbahn des Läufers versetzt ist. Andere Anordnungen sind aber auch möglich. So können beispielsweise bei einem Linearmotor die Magnetfeld-Sensoren in einer Spiralbahn um die Bewegungsbahn des Läufers herum angeordnet sein.

Bei einem linearen Elektromotor kann der Läufer eine Mehrzahl von Stab-Magneten aufweisen, die auf der Bewegungsbahn des Läufers mit jeweils umgekehrter Polarisierung aneinander angebracht sind. In diesem Fall kann die Länge der einzelnen Permanentmagnete dem Abstand zwischen einem lokalen Nordpol und einem lokalen Südpol bzw. der Hälfte des Abstands benachbarter gleichartiger Maxima des Läufermagnetfelds entsprechen.

Die Mehrzahl von Permanentmagneten sind so angeordnet, dass sie ein Läufermagnetfeld mit einer Mehrzahl von periodisch beabstandeten Maxima erzeugen. Dabei ist es weder notwendig, dass die periodisch beabstandeten Maxima gleich hohe Magnetfeldwerte haben, noch notwendig, dass alle Maxima gleichmäßig beabstandet sind. Es ist zum Beispiel möglich, dass das Läufermagnetfeld zu seinen Enden hin ausfranst, so dass sich dort andere Abstände zwischen Maxima ergeben als in der Mitte des Läufermagnetfelds. Wichtig ist, dass das Läufermagnetfeld eine Mehrzahl von gleichmäßig beabstandeten Maxima hat. Der Abstand zwischen zwei Maxima des Läufermagnetfelds kann auch als Polabstand bezeichnet werden. Der Polabstand hängt mit der räumlichen Anordnung und gegebenenfalls den Abständen der Permanentmagnete zusammen. Es versteht sich, dass der Abstand zwischen den Maxima des Läufermagnetfelds nicht eine exakte Distanz im geometrischen Sinne ist. Durch Produktionstoleranzen und andere Ungenauigkeiten, insbesondere bei der Positionierung der Permanentmagnete, kann der Abstand zwischen den Maxima des Läufermagnetfelds leicht variieren. Der Abstand zwischen der Mehrzahl von periodisch beabstandeten Maxima ist ein nominaler Abstand.

Bei der Mehrzahl von Messwerten handelt es sich um im Wesentlichen gleichzeitig genommene Messwerte. Somit stellen die Mehrzahl von Messwerten eine Ortsverteilung des durch die Mehrzahl von Permanentmagneten erzeugten Magnetfelds zu einem bestimmten Messzeitpunkt dar. Die Mehrzahl von Messwerten sind Abtastpunkte des Momentanmagnetfelds. Insbesondere sind die Mehrzahl von Messwerten Abtastwerte des in dem Referenzsystem des Stators momentan vorhandenen, von den Permanentmagneten des Läufers erzeugten Magnetfelds. Diese Ortsverteilung des Magnetfelds zu einem bestimmten Messzeitpunkt wird dann bezüglich der oben diskutierten Ortsfrequenz der spezifischen spektralen Signalkomponente analysiert. Die spektrale spezifische Signalkomponente ist diejenige Signalkomponente, die die Position der Mehrzahl von Permanentmagneten anzeigt, weil ihre Ortsfrequenz dem Abstand benachbarter gleichartiger Maxima des Läufermagnetfelds entspricht. Dabei kann die Ausdrucksweise, dass die Ortsfrequenz dem Abstand benachbarter gleichartiger Maxima des Läufermagnetfelds entspricht, bedeuten, dass die Abtastpunkte auf genau diese Ortsfrequenz hin analysiert werden. Es ist aber auch möglich, dass die spezifische spektrale Signalkomponente eine Ortsfrequenz hat, die zusätzlich zu dem Abstand benachbarter gleichartiger Maxima den Versatz der Magnetfeldsensoren gegenüber den Permanentmagneten berücksichtigt. Auch in diesem Fall entspricht die Ortsfrequenz der spezifischen spektralen Signalkomponente dem Abstand benachbarter gleichartiger Maxima im Sinne der Erfindung. Die Ortsfrequenz ist lediglich an die Geometrie der Anordnung von Magnetfeld-Sensoren zu Permanentmagneten angepasst. Der Ausdruck im Wesentlichen gleichzeitig genommene Messwerte bringt zum Ausdruck, dass die Messwerte möglichst eine Momentaufnahme des Magnetfelds repräsentieren sollen. Von dieser Ausdrucksweise ist aber abgedeckt, dass die Messwerte einen gewissen zeitlichen Versatz zueinander aufweisen können. Dies kann z.B. dann der Fall sein, wenn die Messwerte zu einer Folge nacheinander genommener Messungen gehören, z.B. wenn analoge Magnetfeld-Sensoren verwendet werden, deren Ausgänge der Reihe nach an einen Analog-Digital-Wandler angelegt werden, und die digitalisierten Messdaten dadurch Messungen zu leicht unterschiedlichen Zeitpunkten repräsentieren. Generell kann es in der Signalverarbeitungskette praktische Einschränkungen geben, auf Grund derer eine vollkommene zeitliche Synchronisation der Messwerte im konkreten Anwendungsfall nicht möglich oder wegen der höheren Komplexität / Parallelität nicht erwünscht ist.

Der Stator kann mit einer Vielzahl von Elektromagneten versehen sein, mittels derer der Läufer des Elektromotors angetrieben wird. Die Elektromagneten können Spulen bzw. Windungen sein/haben, durch die mittels geeigneter Ansteuerung zeitlich veränderliche magnetische Felder erzeugt werden können.

Erfindungsgemäß wird das Bestimmen der Position des angetriebenen Läufers mittels des Phasenwinkels des spezifischen spektralen Signalkomponente durchgeführt. Durch den Phasenwinkel kann bestimmt werden, wie weit ein Maximum des durch die Mehrzahl von Permanentmagneten erzeugten Magnetfelds von einer bekannten Position, z. B. von einer Position eines bestimmten Magnetfeld-Sensors, entfernt ist. Auf diese Weise kann die Position des angetriebenen Läufers besonders genau und effizient bestimmt werden. Gegenüber der Bestimmung der Position des angetriebenen Läufers mittels der Amplitude der spezifischen spektralen Signalkomponente ist die Bestimmung mittels des Phasenwinkels robuster. Die Amplitude ändert sich recht schnell bezüglich des Abstands zwischen Permanentmagneten und Magnetfeld-Sensoren, während die relative Position der Maxima zueinander auch mit Abstand von den Permanentmagneten genau und zuverlässig bestimmt werden kann. Auch kann es bei der Produktion des Läufers mit weniger Aufwand verbunden sein, eine sehr genaue Positionierung der Permanentmagnete zu erreichen, als die Magnetisierung der Permanentmagnete in sehr engen Grenzen zu halten. Somit kann die Bestimmung der Position mittels des Phasenwinkels einen besseren Kompromiss zwischen Aufwand / Komplexität und Genauigkeit ermöglichen.

Erfindungsgemäß beinhaltet das Bestimmen der Position des angetriebenen Läufers ein Umrechnen des Phasenwinkels der spezifischen spektralen Signalkomponente in einen Versatz des angetriebenen Läufers gegenüber einer bekannten Position. Dabei kann die bekannte Position durch momentane Messgrößen in Verbindung mit Produktionsdaten des Gesamtsystems bekannt sein. Zum Beispiel kann die bekannte Position bekannt sein durch eine Bestimmung desjenigen Magnetfeld-Sensors, der am nächsten zu einem bestimmten Punkt des Läufers ist, in Verbindung mit den Produktionsdaten, aus denen sich ergibt, wo dieser Magnetfeld-Sensor angeordnet ist. Produktionsbedingte Abweichungen von den Nominalpositionen der Magnetfeld-Sensoren können ausgemessen werden und in die Berechnung der Position des angetriebenen Läufers einbezogen werden. Es ist auch möglich, dass die bekannte Position aus der Ansteuerung der Elektromagnete des Stators bekannt ist. In anderen Worten, es ist möglich, dass über die Ansteuerung der Elektromagnete eine Position des Läufers geschätzt werden kann, welche als bekannte Position angesehen wird, und dass die genaue Position des Läufers durch den beschriebenen Versatz auf Grundlage des Phasenwinkels der spezifischen spektralen Signalkomponente bestimmt wird.

Gemäß einer weiteren Ausführungsform wird das Bestimmen der spezifischen spektralen Signalkomponente durch ein Anwenden des Görtzel-Algorithmus auf mindestens einen Teil der Mehrzahl von Messwerten durchgeführt. Durch den Görtzel-Algorithmus wird aus den Abtastpunkten bzw. aus einer Untermenge der Abtastpunkte des Momentanmagnetfelds eine einzelne spektrale Signalkomponente extrahiert. Demzufolge kann die spezifische spektrale Signalkomponente bestimmt werden, ohne dass eine umfassende Analyse des Frequenzspektrums des durch die Abtastpunkte gebildeten Signals nötig ist. Mit dem Görtzel-Algorithmus ist somit ein sehr effizientes, schnelles und Ressourcen schonendes Bestimmen der spezifischen spektralen Signalkomponente möglich. Der Görtzel-Algorithmus wird auch als Görtzel-Funktion bezeichnet. Eine Beschreibung des Görtzel-Algorithmus an sich sowie das Bestimmen einer beliebigen spektralen Komponente mittels des Görtzel-Algorithmus kann zum Beispiel der folgenden Publikation entnommen werden: Petr Sysel und Pavel Rajmic: Goertzel algorithm generalized to non-integer multiples of fundamental frequency, EURASIP Journal on Advances in Signal Processing 2012. Der Inhalt dieses Dokuments wird vollumfänglich per Verweis in die vorliegende Patentanmeldung einbezogen.

Gemäß einer weiteren Ausführungsform wird das Bestimmen der spezifischen spektralen Signalkomponente durch ein Anwenden der Fast Fourier Transformation (FFT) auf mindestens einen Teil der Mehrzahl von Messwerten durchgeführt. Die Fast Fourier Transformation ist eine effiziente Implementierung einer diskreten Fourier Transformation, mittels derer eine spektrale Analyse eines durch Abtastpunkte definierten Signals durchgeführt werden kann. Aus der spektralen Analyse kann dann die spezifische spektrale Signalkomponente bestimmt werden. Die Fast Fourier Transformation stellt somit eine Alternative zu dem oben genannten Görtzel-Algorithmus dar, um die spezifische spektrale Signalkomponente aus den Abtastpunkten bzw. aus einer Untermenge der Abtastpunkte zu bestimmen.

Erfindungsgemäß weist das Verfahren weiterhin den folgenden Schritt auf: Auswählen einer Untermenge der Mehrzahl von Messwerten. In diesem Fall wird die spezifische spektrale Signalkomponente in der Untermenge der Mehrzahl von Messwerten bestimmt. In anderen Worten, nur eine Untermenge der Abtastpunkte des Momentanmagnetfelds wird für die Bestimmung der spezifischen spektralen Signalkomponente verwendet. Das Auswählen der Untermenge der Mehrzahl von Messwerten als Abtastpunkte erlaubt ein Begrenzen der Messwerte auf eine Untermenge vergleichsweise relevanter Messwerte, wodurch eine hohe Genauigkeit bei der anschließenden Bestimmung der spezifischen spektralen Signalkomponenten und der anschließenden Bestimmung der Position des angetriebenen Läufers ermöglicht werden kann.

Gemäß einer weiteren Ausführungsform stammt die Untermenge der Mehrzahl von Messwerten von einander benachbart angeordneten Magnetfeld-Sensoren. Auf diesem Weg wird eine zusammenhängende Menge von Messwerten ausgewählt, aus denen in besonders zuverlässiger Weise die spezifische spektrale Signalkomponente bestimmt werden kann.

Gemäß einer weiteren Ausführungsform umfasst die Untermenge der Mehrzahl von Messwerten zwischen 4 und 10 Messwerte, insbesondere zwischen 5 und 8 Messwerte, weiter insbesondere 6 Messwerte. Die genannte Anzahl von Messwerten ermöglicht einen besonders guten Kompromiss aus hoher Zuverlässigkeit und Genauigkeit sowie gut beherrschbarer Komplexität für das Bestimmen der spezifischen spektralen Signalkomponente.

Gemäß einer weiteren Ausführungsform weist das Auswählen der Untermenge der Mehrzahl von Messwerten die folgenden Schritte auf: Ordnen der Mehrzahl von Messwerten entsprechend der räumlichen Anordnung der Magnetfeld-Sensoren entlang der Bewegungsbahn des Läufers; Bestimmen des ersten Messwerts, dessen Absolutwert einen vorbestimmten Schwellwert überschreitet; und Auswählen des genannten ersten Messwerts und benachbarter Messwerte als die genannte Untermenge der Mehrzahl von Messwerten. Auf diese Weise kann sichergestellt werden, dass möglichst relevante Messwerte für die Bestimmung der spezifischen spektralen Signalkomponente herangezogen werden, wobei durch die Auswahl benachbarter Messwerte eine hohe Zuverlässigkeit erzielt wird. Auch findet das Auswählen auf besonders effiziente Weise statt, da nur der erste Messwert über eine konkrete Analyse der Messwerte herausgepickt wird und die anderen Messwerte der genannten Untermenge über die Zuordnung zu den Magnetfeld-Sensoren ausgewählt werden. Bei dem Schritt des Bestimmens des ersten Messwerts, dessen Absolutwert den vorbestimmten Schwellwert überschreitet, kann die Richtung, aus der nach dem genannten ersten Messwert gesucht wird, in geeigneter Weise für die betreffende Anwendung festgelegt werden.

Gemäß einer weiteren Ausführungsform wird die Position des angetriebenen Läufers berechnet aus der Position desjenigen Magnetfeld-Sensors, der den ersten Messwert geliefert hat, und dem Versatz des angetriebenen Läufers, den der Phasenwinkel der spezifischen spektralen Komponente anzeigt. In anderen Worten, die genaue Position des Läufers wird bestimmt aus dem Versatz des angetriebenen Läufers gegenüber dem genannten "demjenigen" Magnetfeld-Sensor, der den ersten Messwert geliefert hat. Die Position des Magnetfeld-Sensors, der den ersten Messwert geliefert hat, ist ein Beispiel einer bekannten Position, zu der der Versatz addiert wird bzw. von der der Versatz subtrahiert wird.

Gemäß einer alternativen Ausführungsform wird die Untermenge der Mehrzahl von Messwerten ausgewählt als diejenige Menge einer vorbestimmeten Anzahl von Messwerten benachbarter Magnetfeld-Sensoren, die den größten summierten Absolutwert hat. Auf diese Weise werden diejenigen Messwerte ausgesucht, die den Bereich des stärksten Magnetfelds beschreiben und dadurch eine hohe Zuverlässigkeit bei der Positionsbestimmung versprechen.

Gemäß einer weiteren Ausführungsform weist das Bestimmen der Mehrzahl von Messwerten die folgenden Schritte auf: Erstellen von Messdaten durch die Mehrzahl von Magnetfeld-Sensoren; und Erzeugen der Mehrzahl von Messwerten durch Kalibrieren der Messdaten, wobei das Kalibrieren ein Kompensieren von Antriebs-Magnetfeld-Komponenten aufweist, die im Betrieb von Antriebselementen des Elektromotors, insbesondere von stromdurchflossenen Spulen des Elektromotors, erzeugt werden. Auf diese Weise werden aus Roh-Messdaten, die alle Magnetfeld-Komponenten erfassen und somit sowohl das durch die Permanentmagnete erzeugte Magnetfeld als auch das durch die Elektromagnete erzeugte Magnetfeld als Signalkomponenten beinhalten, eine Mehrzahl von Messwerten erstellt, die im Wesentlichen nur die Signalkomponente des durch die Permanentmagnete erzeugten Magnetfelds umfassen. Das Kompensieren von Antriebs-Magnetfeld-Komponenten kann somit auch als ein Entfernen von Signal-Komponenten betrachtet werden, die durch die Elektromagnete des Stators und somit nicht durch die Permanentmagnete des Läufers erzeugt werden. Auf diese Weise kann die spezifische spektrale Signalkomponente in besonders zuverlässiger Weise bestimmt werden. Das Kompensieren von Antriebs-Magnetfeld-Komponenten kann auf algorithmische Weise, z.B. über entsprechende Filter, oder über die Verwendung von Look-Up-Tabellen erfolgen, wobei die momentane Ansteuerung der Antriebselemente des Elektromotors, d.h. die Ansteuerung der Elektromagneten des Elektromotors, als Eingabe dienen kann.

Gemäß einer weiteren Ausführungsform weist das Kalibrieren weiterhin auf: Kompensieren von Offsets der Mehrzahl von Magnetfeld-Sensoren; und/oder Kompensieren von Produktionsungenauigkeiten, insbesondere Kompensieren von Messfehlern, die durch ungenau positionierte Magnetfeld-Sensoren hervorgerufen sind. Auf diese Weise können inhärent ungenaue Messungen der Magnetfeldsensoren, sei es durch Sensor-inhärente Offsets der Magnetfeld-Sensoren oder durch gegenüber einer nominalen Position ungenau positionierte Magnetfeld-Sensoren, ausgeglichen werden. Auf diese Weise kann wiederum die spezifische spektrale Signalkomponente auf besonders zuverlässige Weise bestimmt werden.

Gemäß einer weiteren Ausführungsform werden die Schritte des Bestimmens der Mehrzahl von Messwerten, des Bestimmens der spezifischen spektralen Signalkomponente und des Bestimmens der Position des angetriebenen Läufers bei Bewegung des Läufers wiederholt ausgeführt. Durch das wiederholte Ausführen der genannten Schritte im Betrieb kann die Position des angetriebenen Läufers für verschiedene Zeitpunkte bestimmt werden, so dass in vorzugsweise regelmäßigen Abständen eine aktualisierte Position des Läufers zur Verfügung steht. In einer bestimmten Ausführungsform werden die genannten Schritte mindestens einmal pro Millisekunde ausgeführt. In anderen Worten, die genannten Schritte werden mindestens tausend Mal pro Sekunde ausgeführt, so dass mindestens tausend Mal pro Sekunde eine aktualisierte Position des Läufers zur Verfügung gestellt wird. In einer weiteren Ausführungsform werden die genannten Schritte mindestens einmal alle 100 Millisekunden ausgeführt. Dadurch sind noch aktuellere Positionsdaten für den Läufer verfügbar. Wenn die Schritte des Auswählens einer Untermenge der Mehrzahl von Messwerten und/oder des Kalibrierens der Messdaten in einer Ausführungsform implementiert sind, können auch diese Schritte oder einer dieser Schritte gleichermaßen wiederholt ausgeführt werden. Das gilt auch für alle weiteren hierin beschriebenen Schritte bzw. Modifikationen des Verfahrens.

Beispielhafte Ausführungsformen der Erfindung umfassen weiterhin ein Verfahren zum Bewegen eines angetriebenen Läufers eines Elektromotors, wobei das Verfahren die folgenden Schritte aufweist: Bestimmen der Position des angetriebenen Läufers gemäß einem Verfahren zum berührungslosen Bestimmen der Position des angetriebenen Läufers, wie in jeder beliebigen der obigen Ausführungsformen beschrieben; und Bewegen des angetriebenen Läufers auf Basis der bestimmten Position des angetriebenen Läufers. Auf diese Weise wird eine geregelte Bewegung des angetriebenen Läufers ermöglicht, wobei das Bewegen des angetriebenen Läufers von der bestimmten Position des angetriebenen Läufers abhängt. Somit liegt eine geschlossene Regelschleife vor, aufgrund derer die Bewegungen des angetriebenen Läufers hochpräzise ausgeführt werden können.

Gemäß einer weiteren Ausführungsform weist der Elektromotor eine Mehrzahl von Spulen auf, die entlang der Bewegungsbahn des Läufers angeordnet sind, wobei der Schritt des Bewegens des angetriebenen Läufers ein gesteuertes Anlegen von Strom an die Mehrzahl von Spulen umfasst. Auf diese Weise bilden die Spulen des Elektromotors eine Mehrzahl von Elektromagneten, über die der Läufer mit hoher Genauigkeit bewegt werden kann.

Gemäß einer weiteren Ausführungsform ist der angetriebene Läufer ein Kolben einer Pipettiervorrichtung, wobei durch ein Bewegen des Kolbens Pipettierflüssigkeit aspiriert bzw. dispensiert wird. In einer alternativen Ausführungsform ist der angetriebene Läufer mit einem Kolben einer Pipettiervorrichtung derart gekoppelt, dass durch die Bewegung des angetriebenen Läufers eine Bewegung des Kolbens bewirkt wird. Die Kopplung kann dabei vergleichsweise wenig komplex, wie z.B. über eine Kolbenstange zwischen einem Läufer eines Linearmotors und einem Kolben einer Pipettiervorrichtung, oder durch vergleichsweise komplexe Kopplungen, wie z.B. durch eine Getriebeanordnung zwischen einem drehbeweglichen Rotor und dem Kolben der Pipettiervorrichtung, erfolgen.

Die Erfindung umfasst weiterhin einen Elektromotor mit berührungsloser Positionsbestimmung gemäß Anspruch 9.

Die zusätzlichen Merkmale, Modifikationen und technischen Effekte, die oben mit Bezug auf das Verfahren zum berührungslosen Bestimmen der Position des angetriebenen Läufers eines Elektromotors beschrieben sind, sind auf den Elektromotor mit berührungsloser Positionsbestimmung analog anwendbar. Insbesondere kann die Positionsbestimmungseinheit des Elektromotors so eingerichtet sein, dass sie die modifizierten und/oder zusätzlichen Schritte des oben beschriebenen Verfahrens ausführen kann.

Der angetriebene Läufer des Elektromotors ist gegenüber dem Stator sowie gegenüber der Mehrzahl von Magnetfeldsensoren beweglich. In anderen Worten, der Läufer bewegt sich in einem durch den Stator und die Mehrzahl von Magnetfeld-Sensoren definierten, als statisch bezeichneten Systems. Es wird nochmals betont, dass der Elektromotor ein Linearmotor sein kann, bei dem sich der Läufer linear bezüglich der Mehrzahl von Magnetfeld-Sensoren bewegt. Es ist auch möglich, dass der Elektromotor als Läufer einen drehbeweglichen Rotor hat, der sich in dem aus Stator und Mehrzahl von Magnetfeld-Sensoren gebildeten System dreht.

Gemäß einer weiteren Ausführungsform der Erfindung sind benachbarte Permanentmagnete gegensinnig gepolt. Der Abstand benachbarter verschiedenartiger Maxima des Läufermagnetfelds, d.h. der räumlichen Abstand zwischen einem magnetischen Südpol und einem magnetischen Nordpol des durch die Permanentmagnet-Anordnung erzeugten Läufermagnetfelds, kann der Länge eines Permanentmagneten bzw. dem Abstand benachbarter Permanentmagnete entsprechen.

Gemäß einer weiteren Ausführungsform sind die Mehrzahl von Permanentmagneten in Reihe angeordnet, wobei benachbarte Permanentmagnete mit gleichartigen Polen zueinander hin ausgerichtet sind. Insbesondere können die Permanentmagnete Stabmagnete sein. Die Permanentmagnete können auf der Bewegungsbahn des Läufers in Reihe angeordnet sein. Der Abstand benachbarter gleichartiger Maxima kann dem Doppelten der Länge eines Permanentmagneten entsprechen. Mit einer solchen Anordnung kann ein besonders guter Kompromiss aus hoher Magnetfelddichte und somit hoher Kraft des Elektromotors auf der einen Seite und scharfer Definition der Maxima des Läufermagnetfelds und somit sehr genauer Positionsbestimmung auf der anderen Seite erreicht werden.

Bei einem Linearmotor kann der Läufer über eine Mehrzahl von Permanentmagneten verfügen, die jeweils einen Süd- und Nordpol aufweisen und mit gleichartigen Polen aneinander angeordnet sind. In anderen Worten, benachbarte Permanentmagnete können jeweils mit ihren Nord- bzw. Südpolen zueinander angeordnet sein. Bei einem Elektromotor mit einem drehbeweglichen Rotor können die Permanentmagnete so angeordnet sein, dass benachbarte Permanentmagnete eine zum Luftspalt hin abwechselnde Polung aufweisen. Der Abstand zwischen den Mittelpunkten benachbarter Permanentmagnete ist dann der Polabstand des Läufermagnetfelds. Im Falle des Rotors kann der Polabstand als geometrische Winkelgröße angegeben werden. Es ist aber auch möglich, den Polabstand als geometrische Längengröße anzugeben. Die Ortsfrequenz der spezifischen spektralen Signalkomponente kann auf Basis des radialen Versatzes zwischen den Magnetfeld-Sensoren und den Permanentmagneten gegenüber dem Abstand der Maxima des Läufermagnetfelds entlang der Permanentmagnete angepasst sein. Dies ist ein Beispiel des oben beschriebenen Szenarios, wonach die Ortsfrequenz der spezifischen spektralen Signalkomponente die Geometrie des Gesamtsystems berücksichtigt, aber weiterhin dem Abstand gleichartiger Maxima des Läufermagnetfelds entspricht.

Gemäß einer weiteren Ausführungsform sind die Mehrzahl von Magnetfeld-Sensoren eine Mehrzahl von Hall-Sensoren. Auf diese Weise kann das an den Magnetfeld-Sensoren vorhandene Magnetfeld sehr direkt gemessen werden.

Gemäß einer weiteren Ausführungsform sind die Mehrzahl von Magnetfeld-Sensoren im Wesentlichen gleichmäßig entlang der Bewegungsbahn des Läufers angeordnet. Eine im wesentlichen gleichmäßige Anordnung der Magnetfeld-Sensoren erlaubt einen regelmäßigen Abstand zwischen den Abtastpunkten, wodurch eine besonders genaue und zuverlässige Bestimmung der spezifischen spektralen Signalkomponente ermöglicht wird. Auch ermöglicht eine regelmäßige Anordnung der Magnetfeld-Sensoren ein besonders gutes Herausfiltern der durch die Elektromagnete erzeugten Magnetfeldkomponente. In einem Linearmotor können die Magnetfeld-Sensoren entlang einer Gerade angeordnet sein, was eine sehr übersichtliche und klare Konstruktion erlaubt. Sie können auch anders angeordnet sein, z.B. in einer spiralförmigen Bahn um die Bewegungsbahn des Läufers. In einem Elektromotor mit drehbeweglichem Rotor können die Magnetfeld-Sensoren auf einer Kreisbahn angeordnet sein.

Gemäß einer weiteren Ausführungsform weist der angetriebene Läufer zwischen 4 und 8 Permanentmagnete, insbesondere 5 oder 6 Permanentmagnete auf. Die angegebene Anzahl der Permanentmagnete stellt einen guten Kompromiss zwischen einer effektiven Bewegung des Läufers über die Elektromagnete des Stators und einer guten Positionsbestimmung dar. Insbesondere ermöglicht die angegebene Anzahl der Permanentmagnete einen guten Kompromiss zwischen hoher Genauigkeit und Zuverlässigkeit und gut beherrschbarer Komplexität bei der Bestimmung der spezifischen spektralen Signalkomponente.

Gemäß einer weiteren Ausführungsform sind die Mehrzahl der Permanentmagnete miteinander verklebt. Auf diese Weise wird mit einfachen Mitteln erreicht, dass der Polabstand des Läufermagnetfelds durch die Dimensionen der Permanentmagnete, welche Produktions-technisch gut kontrolliert werden können, festgelegt ist.

Gemäß einer weiteren Ausführungsform beträgt der Abstand benachbarter gleichartiger Maxima des Läufermagnetfelds zwischen 10 mm und 20 mm, insbesondere zwischen 12 mm und 15 mm, weiter insbesondere zwischen 13 mm und 14 mm. Die genannten Werte ermöglichen einen guten Kompromiss aus Dimensionierung des Läufers, Erzielung einer ausreichende Magnetfelddichte für die Bewegung des Läufers und gut verarbeitbarer Auflösung bei der Bestimmung der spezifischen spektralen Signalkomponente.

Erfindungsgemäß ist die Positionsbestimmungseinheit eingerichtet, die Position des angetriebenen Läufers mittels des Phasenwinkels der spezifischen spektralen Signalkomponente zu bestimmen. Dabei ist Positionsbestimmungseinheit eingerichtet, den Phasenwinkel der spezifischen spektralen Signalkomponente in einen Versatz des angetriebenen Läufers gegenüber einer bekannten Position umzurechnen.

Gemäß einer weiteren Ausführungsform ist die Positionsbestimmungseinheit eingerichtet, die spezifische spektrale Signalkomponente durch ein Anwenden des Görtzel-Algorithmus auf die Abtastpunkte zu bestimmen. Es ist auch möglich, die spezifische spektrale Signalkomponente durch ein Anwenden der Fast Fourier Transformation (FFT) oder durch eine andere geeignete Art der Signalverarbeitung zu bestimmen.

Erfindungsgemäß ist die Positionsbestimmungseinheit eingerichtet, eine Untermenge der Mehrzahl von Messwerten auszuwählen und die spezifische spektrale Signalkomponente in der Untermenge der Mehrzahl von Messwerten zu bestimmen.

Gemäß einer weiteren Ausführungsform umfasst die Untermenge der Mehrzahl von Messwerten zwischen 4 und 10 Messwerte, insbesondere zwischen 5 und 8 Messwerte, weiter insbesondere 6 Messwerte.

Gemäß einer weiteren Ausführungsform weist die Positionsbestimmungseinheit einen Mikrocontroller auf. Mit einem Mikrocontroller kann die spezifische spektrale Signalkomponente und die Position des angetriebenen Läufers sehr schnell und effizient bestimmt werden. Der Mikrocontroller kann auf diese Verarbeitungsschritte hin optimiert sein, so dass die Position des angetriebenen Läufers nahezu in Realzeit zur Verfügung gestellt werden kann. Es ist aber auch möglich, einen Universal-Mikrocontroller für die Bestimmung der Position des Läufers aus den Messdaten zu verwenden. Generell kann für die Positionsbestimmung jegliche Art von Datenverarbeitungsvorrichtung, z.B. auch ein Computer mit entsprechender Software, verwendet werden. Beispielhafte geeignete Mikrocontroller sind der Renesas ^{®} RX71M und der Renesas ^{®} RX63T.

Gemäß einer weiteren Ausführungsform weist der Stator eine Mehrzahl von Spulen auf, die entlang der Bewegungsbahn des Läufers angeordnet sind, wobei der angetriebene Läufer durch ein gesteuertes Anlegen von Strom an die Mehrzahl von Spulen bewegbar ist.

Gemäß einer weiteren Ausführungsform ist die Anordnung der Mehrzahl von Magnetfeld-Sensoren auf die Anordnung der Mehrzahl von Spulen abgestimmt. Bei einem Linearmotor können die Magnetfeld-Sensoren und die Spulen mit dem gleichen regelmäßigen Abstand entlang der Bewegungsbahn des Läufers angeordnet sein. Bei einem Elektromotor mit Rotor können die Magnetfeld-Sensoren und die Spulen mit dem gleichen regelmäßigen Winkelabstand, betrachtet von der Mitte des Rotors, angeordnet sein. Eine solche Abstimmung der Anordnung von Magnetfeld-Sensoren und der Anordnung von Spulen erlaubt ein besonders zuverlässiges und genaues Erzeugen der Messwerte aus den Roh-Messdaten, weil die Magnetfelder der Spulen aus Sicht der Magnetfeld-Sensoren sehr regulär sind.

Gemäß einer weiteren Ausführungsform weist der Elektromotor weiterhin eine Steuereinheit auf, die mit der Positionsbestimmungseinheit gekoppelt ist und eingerichtet ist, den Stromfluss durch die Mehrzahl von Spulen auf Basis der bestimmten Position des angetriebenen Läufers zu steuern. Auf diesem Weg ist eine geschlossene Regelschleife zur Verfügung gestellt, bei der die Position des Läufers über die Mehrzahl von Spulen auf Basis der aus Messdaten bestimmten Position des Läufers geregelt wird.

Gemäß einer weiteren Ausführungsform ist der Elektromotor ein Linearmotor, wobei der angetriebene Läufer linear auf der Bewegungsbahn beweglich ist.

Gemäß einer alternativen Ausführungsform ist der angetriebene Läufer ein bezüglich des Stators drehbeweglicher Rotor, wobei die Bewegungsbahn des Läufers im Wesentlichen kreisförmig ist. Wie oben ausgeführt worden ist, kann die Bewegungsbahn des Läufers dabei als Summe aller Punkte definiert sein, die eine bestimmte Komponente des Rotors während einer Umdrehung durchläuft. Insbesondere kann die Bewegungsbahn des Läufers als die Menge der Punkte definiert sein, die ein Punkt einer dem Luftspalt zugewandten Oberfläche eines Permanentmagneten während einer Umdrehung durchläuft.

Gemäß einer weiteren Ausführungsform weist der Elektromotor einen Referenzpunktsensor auf, der ein Vorbeilaufen eines vorbestimmten Bereichs des Rotors detektiert. Auf diese Weise kann die Anzahl der Umdrehungen des Rotors gemessen werden. Gemeinsam mit der oben beschriebenen Positionsbestimmung des Läufers, d.h. des Rotors in dem vorliegenden Fall, kann somit eine Gesamtdrehung des Rotors bestimmt werden.

Jegliche der oben beschriebenen Ausführungsformen des Verfahrens zum berührungslosen Bestimmen der Position eines angetriebenen Läufers eines Elektromotors sind auf den Elektromotor in allen oben beschriebenen Ausführungsformen anwendbar. Die Kombination aller Merkmale der Ausführungsformen des Verfahrens, einzeln oder in jeder beliebigen Kombination, mit allen Merkmalen der Ausführungsformen der Vorrichtung des Elektromotors, einzeln oder in jeder beliebigen Kombination, ist hiermit explizit offenbart, sofern sie durch die beigefügten Ansprüche abgedeckt sind.

Es ist allgemein anzumerken, dass das berührungslose Bestimmen der Position des Läufers ein Bestimmen der Absolutposition der Läufers betreffen kann oder das Bestimmen einer Relativposition des Läufers betreffen kann. In anderen Worten, das Ergebnis der Positionsbestimmung kann eine Absolutposition sein oder eine Relativposition gegenüber einer irgendwie anderweitig bestimmten groben Lage des Läufers.

Beispielhafte Ausführungsformen der Erfindung umfassen weiterhin ein Pipettiersystem zum Aspirieren und Dispensieren von Pipettierflüssigkeit, aufweisend: einen Kolben, der ein flüssigkeitszugewandtes Ende und ein flüssigkeitsabgewandtes Ende hat; einen Pipettierkanal, in dem der Kolben angeordnet ist und an dessen Ende eine Pipettierspitze angeordnet ist, wobei durch Bewegen des Kolbens ein Aspirieren bzw. Dispensieren von Pipettierflüssigkeit durch die Pipettierspitze möglich ist; und einen Elektromotor gemäß einer der oben beschriebenen beispielhaften Ausführungsformen, wobei der angetriebene Läufer der Kolben oder Teil des Kolbens ist oder wobei der angetriebene Läufer mit dem Kolben antriebsmäßig gekoppelt ist. Die zusätzlichen Merkmale, Modifikationen und technischen Effekte, die oben bezüglich des Elektromotors und bezüglich des Verfahrens zum berührungslosen Bestimmen der Position des angetriebenen Läufers des Elektromotors beschrieben sind, sind analog auf das Pipettiersystem zum Aspirieren und Dispensieren von Pipettierflüssigkeit anwendbar.

In einem Pipettiersystem kann der Elektromotor mit berührungsloser Positionsbestimmung, wie in den oben beschriebenen beispielhaften Ausführungsformen dargelegt, besonders vorteilhaft verwendet werden. Die Positionsbestimmung findet mit dem beschriebenen Elektromotor in besonders schneller und genauer Weise statt. Somit kann der Kolben des Pipettiersystems mit hoher Dynamik geregelt werden. Dies ist bei Pipettiersystemen besonders vorteilhaft, weil diese, zum Beispiel bei Verwendung in der Laborautomation, eine große Anzahl von Pipettiervorgängen in möglichst kurzer Zeit und mit möglichst hoher Präzision ausführen sollen. Ganz besonders vorteilhaft kann ein solcher Elektromotor bei relativ neuartigen Pipettiersystemen eingesetzt werden, die den Kolben mit sehr hoher Geschwindigkeit für einen Pipettiervorgang vor und zurück bewegen, wobei der Hub des Kolbens um ein Vielfaches höher ist als das Volumen der aspirierten bzw. dispensierten Flüssigkeit und wobei das Aspirieren bzw. Dispensieren der Flüssigkeit über eine mit hoher Dynamik aufgebaute Druckwelle vonstatten geht. Gerade in einem solchen, von hoher Dynamik gekennzeichneten System ist die schnelle und präzise Positionsbestimmung des Läufers des Elektromotors äußerst wertvoll. Ein solches Pipettiersystem hoher Dynamik ist in WO 2017/0107084 A1 offenbart.

Gemäß einer weiteren Ausführungsform hat zumindest das flüssigkeitszugewandte Ende des Kolbens eine Abdichtung gegenüber dem Pipettierkanal, wodurch zwischen dem flüssigkeitszugewandten Ende des Kolbens und der Pipettierspitze ein abgedichtetes Volumen in dem Pipettierkanal vorhanden ist. Das flüssigkeitsabgewandte Ende des Kolbens kann ebenfalls eine Abdichtung gegenüber dem Pipettierkanal haben. Durch das Vorsehen von zwei Abdichtungen an beiden Enden des Kolbens kann dafür gesorgt werden, das der Kolben innerhalb des Pipettierkanals ein im Wesentlichen symmetrisches Verhalten für die zwei Bewegungsrichtungen hat.

Beispielhafte Ausführungsformen der Erfindung umfassen weiterhin ein Computerprogramm bzw. ein Computerprogrammprodukt, welches Programmanweisungen enthält, die bei Ausführung auf einer Datenverarbeitungsanlage ein Verfahren gemäß einer der oben beschriebenen Ausführungsformen durchführen. Dabei können die einzelnen Schritte des Verfahrens durch die Programmanweisungen veranlasst werden und durch andere Komponenten ausgeführt werden oder in der Datenverarbeitungsanlage selbst ausgeführt werden.

Weitere beispielhafte Ausführungsformen der Erfindung werden nachfolgend mit Bezug auf die Figuren beschrieben.
Fig. 1 zeigt einen Elektromotor gemäß einer beispielhaften Ausführungsform der Erfindung, teilweise in schematischer Längsschnitt-Darstellung und teilweise in Blockbild-Darstellung;
Fig. 2 zeigt einen Elektromotor gemäß einer weiteren beispielhaften Ausführungsform der Erfindung, teilweise in schematischer Querschnitt-Darstellung und teilweise in Blockbild-Darstellung;
Fig. 3 zeigt ein Blockdiagramm der Signalverarbeitungskette in einem Elektromotor gemäß einer beispielhaften Ausführungsform der Erfindung;
Fig. 4 zeigt beispielhafte Messwerte der Magnetfeld-Sensoren und illustriert ein Beispiel einer Bestimmung der spezifischen spektralen Signalkomponente;
Fig. 5 zeigt ein Pipettiersystem gemäß einer beispielhaften Ausführungsform der Erfindung, teilweise in schematischer Längsschnitt-Darstellung und teilweise in Blockbild-Darstellung;
Fig. 6 zeigt ein Läufermagnetfeld eines beispielhaften Läufers, wie er beispielsweise in dem Pipettiersystem der Fig. 5 verwendet werden kann.

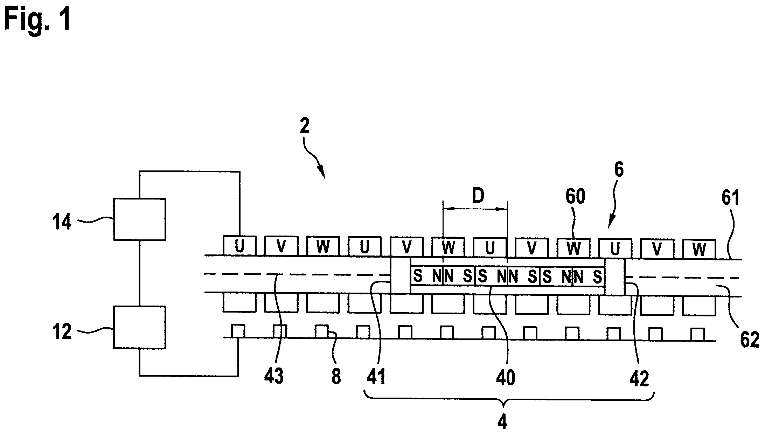

Fig. 1 zeigt einen Elektromotor 2 gemäß einer beispielhaften Ausführungsform der vorliegenden Erfindung. Der Elektromotor 2 hat einen Stator 6 und eine Rotor 4. Außerdem hat der Elektromotor 2 eine Mehrzahl von Magnetfeld-Sensoren 8, eine Positionsbestimmungseinheit 12 und eine Steuereinheit 14. Der Elektromotor 2 ist ein Linearmotor, bei dem sich der Läufer 4 auf einer linearen Bewegungsbahn bezüglich des Stators 6 sowie bezüglich der Mehrzahl von Magnetfeld-Sensoren 8 bewegt.

Der Stator 6 weist einen Kanal 62 auf, der durch einen Hohlzylinder 61 gebildet ist. Um den Hohlzylinder 61 herum ist eine Mehrzahl von Spulen 60 angeordnet. In dem vorliegenden Beispiel sind zwölf Spulen 60 um den Hohlzylinder 61 herum angeordnet. Die Spulen 60 werden zur Bewegung des Läufers 4 mittels Drei-Phasen-Strom angesteuert. Zur Verdeutlichung des Drei-Phasen-Stroms sind die Spulen 60 abwechselnd mit den Buchstaben U, V und W versehen. Es wird betont, dass das Anlegen von Drei-Phasen-Strom rein exemplarisch ist und dass jede geeignete Art von Stromfluss durch die Spulen 60 verwendet werden kann, um eine magnetische Kraft auf den Läufer 4 auszuüben. Es ist dem Fachmann geläufig, wie er Spulen eines Stators mit Strom beaufschlagen kann, um eine magnetische Kraft auf einen Läufer auszuüben. Demzufolge sind keine weiteren Ausführungen bezüglich der konkreten Stromflüsse durch die Spulen 60 nötig.

Der Läufer 4 weist eine Mehrzahl von Permanentmagneten 40 auf. Im vorliegenden Beispiel hat der Läufer 4 sechs Permanentmagnete 40. Die sechs Permanentmagnete 40 sind jeweils Stabmagnete, die an ihrem einen Ende eine Südpol haben und an ihrem anderen Ende einen Nordpol haben. Die sechs Permanentmagnete 40 sind gegensinnig gepolt zueinander angeordnet. In anderen Worten, der Nordpol des ersten Permanentmagneten ist angrenzend an den Nordpol des zweiten Permanentmagneten angeordnet, der Südpol des zweiten Permanentmagneten ist angrenzend an den Südpol des dritten Permanentmagneten angeordnet, der Nordpol des dritten Permanentmagneten ist angrenzend an den Nordpol des vierten Permanentmagneten angeordnet, usw. Die aneinander angrenzenden Enden der Permanentmagnete 40 sind miteinander verklebt, so dass die sechs Permanentmagnete 40 eine Einheit bilden. Aus der Anordnung der Permanentmagnete 40 ergibt sich ein alternierendes Läufermagnetfeld. Zwischen benachbarten Nordpolen und Südpolen der Anordnung der Permanentmagnete liegt ein festgelegter Polabstand, der der Länge eines einzelnen Permanentmagneten entspricht. Der Abstand zwischen gleichartigen Maxima des Läufermagnetfelds ist mit D bezeichnet und entspricht dem Doppelten der Länge der Permanentmagnete.

Der Läufer 4 ist entlang einer linearen Bewegungsbahn 43 beweglich, die sich durch den Kanal 62 des Stators 6 erstreckt. Der Läufer 4 hat eine erste Endkappe 41 und eine zweite Endkappe 42. Durch die Endkappen 41 und 42 ist der Läufer 4 in dem Kanal 62 derart gelagert, dass er sich entlang der Bewegungsbahn 43 bewegen kann, aber in Richtungen orthogonal zu der Bewegungsbahn 43 im Wesentlichen nicht bewegbar ist.

In der beispielhaften Ausführungsform von Fig. 1 hat der Elektromotor 2 zwölf Magnetfeld-Sensoren 8. Die Magnetfeld-Sensoren 8 sind Hall-Sensoren. Beispielhafte geeignete Hall-Sensoren sind der Allegro ^{®} A1308LLHLX-1-T und der EQ-433L von Asahi Kasei Microdevices ^{®}.Es können aber auch andere Arten von Magnetfeld-Sensoren verwendet werden. Die Magnetfeld-Sensoren 8 sind entlang der Bewegungsbahn 43 des Läufers 4 angeordnet. Insbesondere sind die Magnetfeld-Sensoren 8 auf einer Gerade angeordnet, die parallel zu der Bewegungsbahn 43 ist. Die Magnetfeld-Sensoren 8 sind außerhalb der Spulen 60 des Stators 6 angeordnet. Die Anordnung der Magnetfeld-Sensoren 8 ist auf die Anordnung der Spulen 60 abgestimmt. Die Anzahl der Magnetfeld-Sensoren 8 entspricht der Anzahl der Spulen 60. Sowohl die Magnetfeld-Sensoren 8 als auch die Spulen 60 sind regelmäßig entlang der Bewegungsbahn 43 des Läufers 40 angeordnet. Jeweils eine Spule und ein Magnetfeld-Sensor sind an der gleichen axialen Position bezüglich der Bewegungsbahn 43 angeordnet.

Die Mehrzahl der Magnetfeld-Sensoren 8 sind mit der Positionsbestimmungseinheit 12 verbunden, wobei aus Übersichtlichkeitsgründen nur die Verbindung zwischen einem Magnetfeld-Sensor und der Positionsbestimmungseinheit12 gezeichnet ist. Die Positionsbestimmungseinheit 12 empfängt Messdaten von den Magnetfeld-Sensoren 8. Aus diesen Messdaten bestimmt die Positionsbestimmungseinheit 12 die Position des Läufers 4, wie unten im Detail beschrieben wird.

Die Positionsbestimmungseinheit 12 ist mit der Steuereinheit 14 gekoppelt und übermittelt im Betrieb die Position des Läufers 4 an die Steuereinheit 14. Die Steuereinheit 14 vergleicht die von der Positionsbestimmungseinheit 12 bestimmte Position des Läufers 4 mit einer gewünschten Position des Läufers 4 und steuert die Spulen 60 des Stators 6 in einer Weise, dass der Läufer 4 auf die gewünschte Position innerhalb des Kanals 62 bewegt wird. Zu diesem Zweck ist die Steuereinheit 14 mit den Spulen 60 verbunden, wobei wiederum aus Übersichtlichkeitsgründen nur eine Verbindung zwischen der Steuereinheit 14 und einer der Spulen 60 gezeichnet ist.

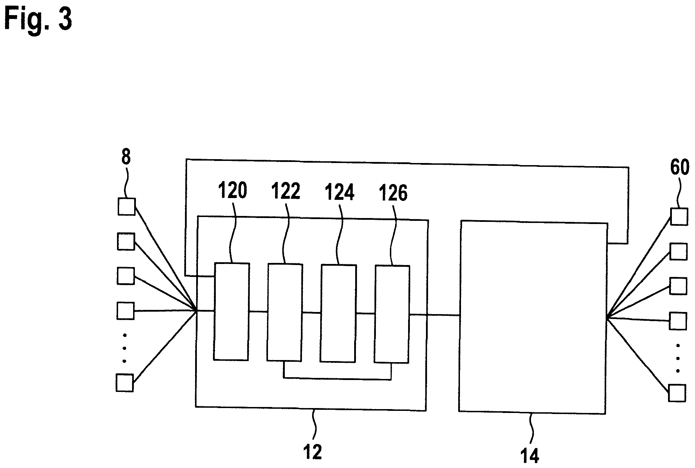

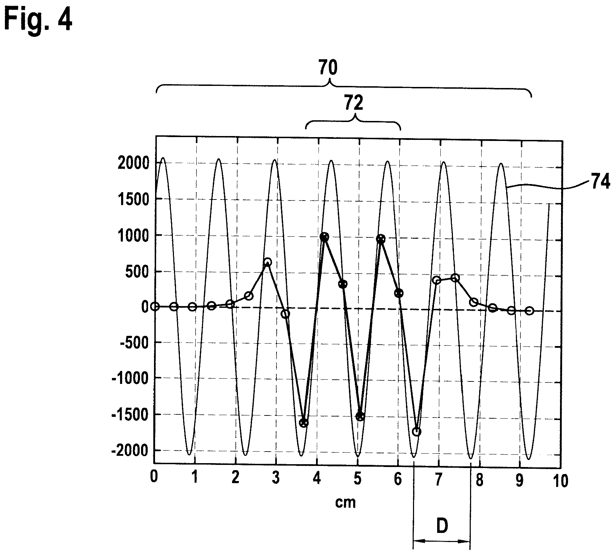

Der Betrieb des Elektromotors 2, insbesondere die Bestimmung der Position des Läufers 4 innerhalb des Stators 6 durch die Positionsbestimmungseinheit 12, wird unten im Detail mit Bezug auf Fig. 3 und 4 beschrieben.

Die Positionsbestimmungseinheit 12 und die Steuereinheit 14 können als getrennte Einheiten ausgeführt sein, wie oben beschrieben. Es ist aber auch möglich, dass die Positionsbestimmungseinheit 12 und die Steuereinheit 14 als eine integrierte Einheit ausgebildet sind. Jede von Positionsbestimmungseinheit 12 und Steuereinheit 14 kann Hardware oder Software oder eine Kombination aus Hardware und Software umfassen. Insbesondere kann sowohl die Positionsbestimmungseinheit 12 als auch die Steuereinheit 14 als auch eine integrierte Einheit einen Prozessor und einen Speicher haben. Es kann ein Computerprogramm vorhanden sein, das die Verfahrensschritte zum Betrieb des Elektromotors 2, inklusive der Bestimmung der Position des Läufers 4, ausführt bzw. veranlasst.

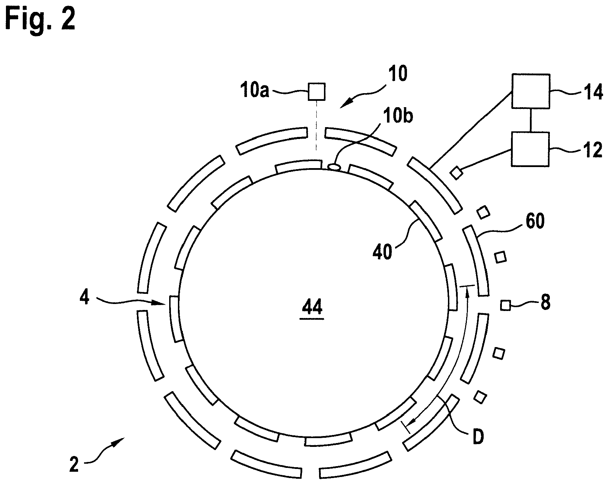

Fig. 2 zeigt einen Elektromotor 2 gemäß einer weiteren beispielhaften Ausführungsform der vorliegenden Erfindung. Wiederum hat der Elektromotor 2 einen Läufer 4 mit einer Mehrzahl von Permanentmagneten 40, einen Stator 6 mit einer Mehrzahl von Spulen 60, eine Mehrzahl von Magnetfeld-Sensoren 8, eine Positionsbestimmungseinheit 12 und eine Steuereinheit 14.

Der Läufer 4 ist im vorliegenden Fall ein drehbeweglicher Rotor. Der Rotor 4 hat einen Rotorkörper 44, an dessen Außenseite die Permanentmagnete 40 angebracht sind. Der Rotor 4 hat zwölf Permanentmagnete, die um den Umfang des Rotorkörpers 44 verteilt sind. Die Permanentmagnete 40 haben eine abwechselnde Polung. Das heißt, von benachbart angeordneten Permanentmagneten 40 ist jeweils einer mit seinem Südpol nach außen hin angeordnet, während der andere mit seinem Nordpol nach außen hin angeordnet ist. Der Polabstand des Läufermagnetfelds ist definiert als der Abstand zwischen den Mittelpunkten benachbarter Permanentmagnete. Der Polabstand kann entweder als geometrischer Winkelwert oder als geometrischer Längenabstand für eine bestimmte radiale Position angegeben werden. Gleichartige Maxima des Läufermagnetfelds haben den Abstand D, d.h. das Doppelte des Polabstands.

Die Spulen 60 des Stators 6 sind um den Rotorkörper 44 und um die Permanentmagnete 40 herum angeordnet, so dass sich zwischen den Permanentmagneten 40 und den Spulen 60 ein Luftspalt ergibt, durch den eine magnetische Kraft von den Spulen 60 auf die Permanentmagnete 40 zur Bewegung des Rotors 4 ausgeübt wird. Die Mehrzahl von Magnetfeld-Sensoren 8 sind um die Spulen 60 herum entlang eines Teils der Umfangs des Rotorkörpers 44 angeordnet. Sie sind somit entlang der Bewegungsbahn des Rotors 4 angeordnet, welche im vorliegenden Beispiel definiert ist als der Kreis, den die Oberflächen der Permanentmagnete 40 bei Rotation des Rotors 4 beschreiben. Der Elektromotor 2 der Fig. 2 hat sechs Magnetfeld-Sensoren 8.

Die Spulen 60 und die Magnetfeld-Sensoren 8 sind in einem Statorgehäuse angeordnet, welches aus Übersichtlichkeitsgründen in Fig. 2 nicht gezeigt ist. Da dem Fachmann viele Möglichkeiten geläufig sind, diese Komponenten in einem Statorgehäuse unterzubringen und den Rotor 4 bezüglich eines solchen Statorgehäuses drehbar zu lagern, sind weitere Ausführungen in diesem Zusammenhang nicht notwendig.

Weiterhin umfasst der Elektromotor 2 einen Referenzpunktsensor 10, der im vorliegenden Beispiel aus einem im Stator 6 angeordneten ersten Element 10a und einem am Rotorkörper 44 angeordneten zweiten Element 10b besteht. Im vorliegenden Beispiel ist das zweite Element 10b eine Farbfläche, während das erste Element 10a ein optischer Sensor ist, welcher imstande ist, die Farbfläche 10b zu detektieren. Weiterhin ist das erste Element 10a mit einem Zähler versehen, der die Durchgänge der Farbfläche 10b im Betrieb protokolliert. Auf diese Weise können die Umdrehungen des Rotors 4 gemessen werden.

Neben dieser Bestimmung der Anzahl der Umdrehungen des Rotors 4 wird die Bestimmung der genauen Drehposition des Rotors 4 von der Positionsbestimmungseinheit 12 mittels der Messwerte der Magnetfeld-Sensoren 8 vorgenommen. Die Position wird dann im Betrieb an die Steuereinheit 14 weitergegeben, welche diese Information nutzt, um die Spulen 60 entsprechend mit Strom zu beaufschlagen, um den Rotor 4 in eine gewünschte Position zu drehen. Wiederum ist in Fig. 2 der Übersichtlichkeit halber nur eine der Verbindungen zwischen Magnetfeld-Sensoren 8 und Positionsbestimmungseinheit 12 sowie eine der Verbindung zwischen Steuereinheit 14 und Spulen 60 gezeichnet. Es sind aber alle Magnetfeld-Sensoren 8 mit der Positionsbestimmungseinheit 12 sowie alle Spulen 60 mit der Steuereinheit 14 verbunden.

Die Positionsbestimmung mittels der Positionsbestimmungseinheit 12 wird auch für den Elektromotor 2 der Fig. 2 unten mit Bezug auf Fig. 3 und 4 beschrieben.

Es wird betont, dass Fig. 1 und Fig. 2 lediglich beispielhafte Anordnungen von Stator, Läufer und Magnetfeld-Sensoren zeigen. Viele andere Anordnungen sind möglich. Es ist zum Beispiel möglich, dass zusätzlich zu den gezeigten, für den Antrieb des Läufers vorgesehenen Permanentmagneten weitere Permanentmagnete vorhanden sind, die das für die Positionsbestimmung verwendete Läufermagnetfeld erzeugen. Diese zusätzlichen Permanentmagnete können mit einem anderen Abstand als die für den Antrieb vorhandenen Permanentmagnete angeordnet sein, um die spezifische spektrale Signalkomponente zuverlässig zu bestimmen. Für den Fall eines Elektromotors mit drehbeweglichem Rotor ist es zum Beispiel möglich, dass solche zusätzlichen Permanentmagnete um den ganzen Umfang des Rotors angeordnet sind, wobei die Magnetfeld-Sensoren nur entlang eines Teils der Bewegungsbahn des Rotors angeordnet sind. Es ist aber auch möglich, dass die zusätzlichen Permanentmagnete nur um einen Teil des Umfangs des Rotors angeordnet sind, wobei die Magnetfeld-Sensoren entlang der gesamten Bewegungsbahn des Rotors angeordnet sind.

Fig. 3 zeigt ein Blockschaltbild der Signalverarbeitungskette in einem Elektromotor gemäß einer beispielhaften Ausführungsform der Erfindung. Die dargestellte Signalverarbeitungskette dient auch zur detaillierten Beschreibung eines Verfahrens zum berührungslosen Bestimmen der Position eines Läufers eines Elektromotors gemäß einer beispielhaften Ausführungsform der Erfindung. Die illustrierte Signalverarbeitungskette kann sowohl in dem Elektromotor gemäß Fig. 1 als auch in dem Elektromotor gemäß Fig. 2 Verwendung finden.

Fig. 3 zeigt die Verbindung der Mehrzahl von Magnetfeld-Sensoren 8 mit der Positionsbestimmungseinheit 12, die Verbindung der Positionsbestimmungseinheit 12 mit der Steuereinheit 14 und die Verbindung der Steuereinheit 14 mit der Mehrzahl von Spulen 60. Im Folgenden wird insbesondere auf die Positionsbestimmungseinheit 12 eingegangen, wobei die einzelnen Schritte der Bestimmung der Position des Läufers aus den Messdaten der Magnetfeld-Sensoren 8 beschrieben werden. Dabei wird zur Veranschaulichung auch auf Fig. 4 verwiesen.

Die Positionsbestimmungseinheit 12 weist ein Kalibrierungsmodul 120, ein Auswahlmodul 122, ein Görtzel-Algorithmus-Modul 124 und ein Positionsberechnungsmodul 126 auf. Das Kalibrierungsmodul 120 ist mit den Magnetfeld-Sensoren 8 verbunden und empfängt die Messdaten von den Magnetfeld-Sensoren 8. Das Kalibrierungsmodul 120 ist weiterhin mit dem Auswahlmodul 122 verbunden. Das Auswahlmodul 122 ist seinerseits mit dem Görtzel-Algorithmus-Modul 124 und mit dem Positionsberechnungsmodul 126 verbunden. Das Görtzel-Algorithmus-Modul 124 ist auch mit dem Positionsberechnungsmodul 126 verbunden. Das Positionsberechnungsmodul 126 ist mit der Steuereinheit 14 verbunden. Außerdem ist die Steuereinheit 14 mit dem Kalibrierungsmodul 120 verbunden.

Das Kalibrierungsmodul 120 empfängt rohe Messdaten von den Magnetfeld-Sensoren 8, d.h. das Kalibrierungsmodul 120 empfängt Messdaten, die die Überlagerung aller an den Orten der Magnetfeld-Sensoren 8 vorhandenen Magnetfelder beschreiben. Dabei können die Magnetfeld-Sensoren jeweils eigene Analog-zu-Digital-Wandler haben. Es ist auch möglich, dass die Ausgänge der Magnetfeld-Sensoren in schneller Folge an den gleichen Analog-zu-Digital-Wandler geschaltet werden, welcher die Messdaten dann als Messreihe in digitaler Form an das Kalibrierungsmodell weitergibt. Ein beispielhafter geeigneter Analog-zu-Digital-Wandler ist der AD7266BCPZ von Analog Devices ^{®}.Das Kalibrierungsmodul 120 filtert die rohen Messdaten und erzeugt Messwerte, die das durch die Permanentmagnete des Läufers erzeugte Magnetfeld an den Orten der Magnetfeld-Sensoren 8 beschreiben. Zu diesem Zweck filtert das Kalibrierungsmodul 120 diejenigen Signalkomponenten aus den Messdaten heraus, die nicht auf die Permanentmagnete zurückgehen. Im vorliegenden Beispiel filtert das Kalibrierungsmodul 120 drei Arten von Signalkomponenten heraus.

Erstens werden die Messdaten um Offset-Werte der Magnetfeld-Sensoren 8 korrigiert. Zur Bestimmung der Offset-Werte werden die Messdaten der Magnetfeld-Sensoren vor dem regulären Betrieb des Elektromotors ohne Läufer im Stator und ohne Stromfluss in den Spulen gemessen. Diese Messungen stellen Offset-Werte dar und werden für die einzelnen Magnetfeld-Sensoren 8 gespeichert. In dem Kalibrierungsmodul 120 werden diese Offset-Werte im regulären Betrieb addiert bzw. subtrahiert.

Zweitens werden die Signalkomponenten des Magnetfelds, die durch die Spulen des Stators erzeugt werden, herausgefiltert. Dazu werden in einem Testbetrieb bekannte Spannungen an die Spulen angelegt, und die resultierenden Magnetfelder werden gemessen, wobei die Test-Messdaten gespeichert werden. Im regulären Betrieb übermittelt die Steuereinheit 14 ein Signal an das Kalibrierungsmodul 120, mit dem die Steuereinheit 14 über die an die Spulen 60 angelegten Spannungen informiert. Das Kalibrierungsmodul greift auf die Test-Messdaten zu und eliminiert die entsprechenden Komponenten in den Messdaten.

Drittens werden ungenaue Platzierungen der Magnetfeld-Sensoren 8 ausgeglichen. Jeder der Magnetfeld-Sensoren 8 hat eine nominale Position, an der er laut Auslegung des Elektromotors platziert sein soll. Es können jedoch Ungenauigkeiten in der Produktion auftreten, durch die die tatsächliche Position eines oder mehrerer der Magnetfeld-Sensoren von der nominalen Position abweicht. Somit misst/messen derjenige bzw. diejenigen Magnetfeld-Sensor(en) nicht das Magnetfeld an der nominalen Position, sondern an der tatsächlichen Position. Über Messungen im Testbetrieb werden entsprechende Korrekturfaktoren bzw. -algorithmen erstellt, mittels derer die Messdaten auf das für die nominale Position geschätzte Magnetfeld umgerechnet wird.

Als Ausgabe stellt das Kalibrierungsmodul eine Menge von Messwerten für das durch die Mehrzahl von Permanentmagneten erzeugte, im Referenzsystem des Stators vorhandene Momentanmagnetfeld zur Verfügung. Es wird betont, dass die Kalibrierung imperfekt sein kann und die Messwerte für das momentane, durch die Mehrzahl von Permanentmagneten erzeugte Magnetfeld Schätzwerte sind. Dies kann sogar der Regelfall sein. Die Messwerte für das momentane, durch die Mehrzahl von Permanentmagneten erzeugte Magnetfeld können daher auch als auf einer tatsächlichen Messung beruhende Schätzwerte beschrieben werden.

Die Messwerte werden an das Auswahlmodul 122 übertragen. In Fig. 4 sind die Messwerte durch Kreise dargestellt und allgemein mit Bezugszeichen 70 versehen. Auch wenn die Anzahl der Messwerte und somit die Anzahl der Magnetfeld-Sensoren nicht mit dem Elektromotor der Fig. 1 übereinstimmt, so kann man sich trotzdem anschaulich vorstellen, dass die von links nach rechts in Fig. 4 gezeigten Messwerte zu einer Anordnung von Magnetfeld-Sensoren entlang eines Linearmotors, wie in Fig. 1 gezeigt, gehören können. Die x-Achse der Fig. 4 ist auf die Einheit cm ausgelegt, wobei die x-Werte den Abstand bezüglich eines Referenzpunktes des Elektromotors, z.B. bezüglich eines Endes eines Kanals eines Linearmotors, anzeigen. Für die Positionsbestimmung des Elektromotors der Fig. 2 kann das Auswahlmodul auch weggelassen sein. Da der Elektromotor der Fig. 2 nur sechs Magnetfeld-Sensoren hat und durch die Anordnung der Permanentmagnete um den ganzen Umfang des Rotorkörpers zu jedem Zeitpunkt ein Teil des Läufermagnetfelds an allen Magnetfeld-Sensoren anliegt, kann eine Reduktion der Messwerte unerwünscht sein.

Das Auswahlmodul 122 empfängt die Menge von Messwerten 70 von dem Kalibrierungsmodul 120 und wählt eine Untermenge relevanter Messwerte aus. Dabei berechnet das Auswahlmodul 122 für jeden Messwert einen Absolutwert des durch die Mehrzahl von Permanentmagneten erzeugten Magnetfelds. Der Absolutwert ist dabei definiert als die absolute Abweichung von einem Sensor-Referenzwert, welcher den Messwert eines Magnetfeld-Sensors bei großer Distanz zu den Permanentmagneten darstellt. In dem Diagramm von Fig. 4 ist der Sensor-Referenzwert als Wert 0 definiert.

Das Auswahlmodul 122 überprüft der Reihe nach für die resultierenden Absolutwerte, beginnend mit dem Absolutwert, der zu dem Magnetfeld-Sensor mit Position 0 cm gehört, welcher Absolutwert über einem vorbestimmten Schwellwert liegt. In der beispielhaften Ausführungsform von Fig. 4 liegt der vorbestimmte Schwellwert bei 800, wobei die Werte als dimensionslose Ausgabewerte angesehen werden und rein beispielhafte Werte haben. Für die in Fig. 4 illustrierten Messwerte ermittelt das Auswahlmodul 122, dass der Absolutwert des Messwerts, der zu dem Magnetfeld-Sensor mit Position 3,7 cm gehört, der erste Absolutwert ist, der über dem vorbestimmten Schwellwert liegt. Auf Grundlage dieser Ermittlung wählt das Auswahlmodul 122 den Messwert, der zu dem Magnetfeld-Sensor mit Position 3,7 cm gehört, und die benachbarten fünf Messwerte als relevante Untermenge aus. Die ausgewählten Messwerte sind in Fig. 4 zur Veranschaulichung mit einem Kreuz versehen und mit Bezugsziffer 72 versehen.

Die sechs ausgewählten Messwerte 72 werden an das Görtzel-Algorithmus-Modul 124 übermittelt. Außerdem übermittelt das Auswahlmodul 122 die Position desjenigen Magnetfeld-Sensors an das Positionsberechnungsmodul 126, dessen Messwert den ersten Absolutwert oberhalb des vorbestimmten Schwellwerts hatte. Im vorliegenden Beispiel übermittelt das Auswahlmodul 122 die Position 3,7 cm an das Positionsberechnungsmodul 126. Durch diese Übermittlung wird dem Positionsberechnungsmodul 126 mitgeteilt, dass eine vorbestimmte Komponente des Läufers, wie unten beschrieben, in der Nähe der Position 3,7 cm ist. Die Position 3,7 cm wir als bekannt Position bezeichnet. Die genaue Position der Läufers kann dann über die Verknüpfung dieser bekannten Position und dem Ergebnis des Görtzel-Algorithmus-Moduls 124 berechnet werden.

Das Görtzel-Algorithmus-Modul 124 empfängt die sechs ausgewählten Messwerte 72 als Grundlage für den Görtzel-Algorithmus. In anderen Worten, die sechs ausgewählten Messwerte 72 sind die Abtastpunkte, an Hand derer der Görtzel-Algorithmus ausgeführt wird. Der Görtzel-Algorithmus bestimmt diejenige spektrale Signalkomponente aus den Abtastpunkten, deren Ortsfrequenz dem Abstand D zweier benachbarter gleichartiger Maxima des Läufermagnetfelds entspricht. Im vorliegenden Beispiel bestimmt der Görtzel-Algorithmus somit den Spektralgehalt des durch die Abtastpunkte gebildeten Signals für diejenige Ortsfrequenz, die dem Doppelten des Polabstands der Permanentmagnete des Läufers entspricht. Die genannte spektrale Signalkomponente bzw. der genannte Spektralgehalt für die genannte spezifische Ortsfrequenz wird auch als spezifische spektrale Signalkomponente bezeichnet. Der Abstand D zweier benachbarter gleichartiger Maxima beträgt im gezeigten Beispiel 1,38 cm.

Die Analyse der Abtastpunkte bezüglich der spezifischen spektralen Signalkomponente beruht auf der Überlegung, dass die Permanentmagnete mit dem festgelegten Polabstand ein Magnetfeld erzeugen, das eine starke oszillierende Komponente bei der Ortsfrequenz hat, die dem Doppelten des Polabstands entspricht. In anderen Worten, der beschriebenen Analyse liegt die Überlegung zugrunde, dass eine Mehrzahl von Permanentmagneten mit einem festgelegten Polabstand auch zu einem Wesentlichen Teil ein sich mit diesem festgelegten Polabstand änderndes Magnetfeld erzeugen. Die Lage dieses Magnetfelds wird über die Spektralanalyse bezüglich der spezifischen spektralen Signalkomponente bestimmt.

Die spezifische spektrale Signalkomponente ist in Fig. 4 mit Bezugszeichen 74 versehen und als Sinus-förmige Kurve über die ganze Länge eingezeichnet. Die spezifische spektrale Signalkomponente 74 lässt sich als kontinuierliche Kurve beschreiben, wie in Fig. 4 dargestellt. Sie lässt sich aber auch durch zwei charakteristische Werte, nämlich durch die Amplitude und den Phasenwinkel, beschreiben. Dabei beschreibt die Amplitude die Stärke der durch die Permanentmagnete erzeugten und mit der spezifischen Ortsfrequenz oszillierenden Magnetfeldkomponente. Der Phasenwinkel beschreibt einen Versatz der oszillierenden Magnetfeldkomponente gegenüber einer bekannten Position, z.B. gegenüber der Position des ersten Magnetfeld-Sensors, dessen Messwert einen Absolutwert über dem vorbestimmten Schwellwert hat, oder gegenüber der Position eines Endes oder anderen Referenzwerts des Elektromotors. Der Versatz ist im vorliegenden Beispiel von Fig. 4 definiert als der Abstand zwischen der Position desjenigen Magnetfeld-Sensors, dessen Messwert den ersten Absolutwert oberhalb des vorbestimmten Schwellwerts hatte, d.h. 3.7 cm im vorliegenden Beispiel, und der Position des nächsten lokalen Maximums oder Minimums der spezifischen spektralen Signalkomponente 74. Im vorliegenden Beispiel ist der Versatz -0,1 cm.

Das Görtzel-Algorithmus-Modul 124 übermittelt den Versatz an das Positionsberechnungsmodul 126, welches aus dem Versatz und der von dem Auswahlmodul 122 empfangenen bekannten Position die Position des angetriebenen Läufers berechnet. Im vorliegenden Beispiel ergibt sich die Position des angetriebenen Läufers zu 3,6 cm, was der Summe von 3,7 cm und -0,1 cm entspricht. Somit hat das Positionsberechnungsmodul 126 die Position des Läufers bestimmt und übermittelt diese Information an die Steuereinheit 14.

Welche Komponente bzw. welches Teil des Läufers an der bestimmten Position des Läufers zu finden ist, liegt an der spezifischen Ausführungsform des Elektromotors und der speziellen Ausgestaltung der oben beschriebenen Signalverarbeitung. Im Beispiel der Fig. 3 und 4 ist die durch die obige Signalverarbeitung bestimmte Position des Läufers die Position des zweiten Pols entlang der Bewegungsbahn des Läufers. Hintergrund der Identifikation der Position des zweiten Pols ist die Überlegung, dass der zweite Pol deutlicher zu identifizieren ist als der erste, weil das durch den ersten Pol erzeugte Magnetfeld auf Grund der Absenz weiterer Pole weiter ausläuft und dadurch schwächer ist. In den Messwerten der Fig. 4 ist das daran zu sehen, dass es vor dem Messwert des Magnetfeld-Sensors an Position 3,7 cm schon einen Ausschlag in die andere Richtung gibt, der weniger stark ist. Der vorbestimmte Schwellwert ist so gewählt, dass der Absolutwert des Magnetfelds des zweiten Pols den vorbestimmten Schwellwert überschreitet. An Hand der bekannten Geometrie des Läufers kann dann die Position jedes beliebigen Teils des Läufers bestimmt werden. Es wird betont, dass es neben der hier beschriebenen Bestimmung der Position des zweite Pols andere Möglichkeiten gibt, die Position einer spezifischen Komponente des Läufers zu bestimmen. Die Position welcher Komponente genau und zuverlässig bestimmt wird, kann der Fachmann für ein gegebenes System entsprechend den individuellen Gegebenheiten auswählen und festlegen.

Die Positionsbestimmungseinheit 12 ist mit Bezug auf Fig. 3 als Kombination mehrerer Module beschrieben. Die Module sind logische Einheiten, die jeweils einen bestimmten Schritt der Signalverarbeitung ausführen. Es ist ersichtlich, dass die Trennung der einzelnen Schritte bei der tatsächlichen Implementierung weniger scharf sein kann bzw. dass die Verarbeitungsschritte oder deren Unterschritte anders gruppiert sein können. Die Positionsbestimmungseinheit kann ein Mikrokontroller sein oder jede andere geeignete Vorrichtung zur Signalverarbeitung.

In der beispielhaften Ausführungsform der Fig. 4 benötigt die Positionsbestimmungseinheit 12 für die Bestimmung der Position des Läufers aus den Messdaten der Magnetfeld-Sensoren zwischen 30 µs und 40 µs. Das heißt, dass die Position des Läufers der Steuereinheit 14 sehr schnell, insbesondere nahezu in Realzeit, zur Verfügung gestellt wird. Die hohe Dynamik der Positionsbestimmungseinheit 12 unterstützt die effektive Regelung der Position des Läufers, auch wenn sich dieser schnell bewegt.

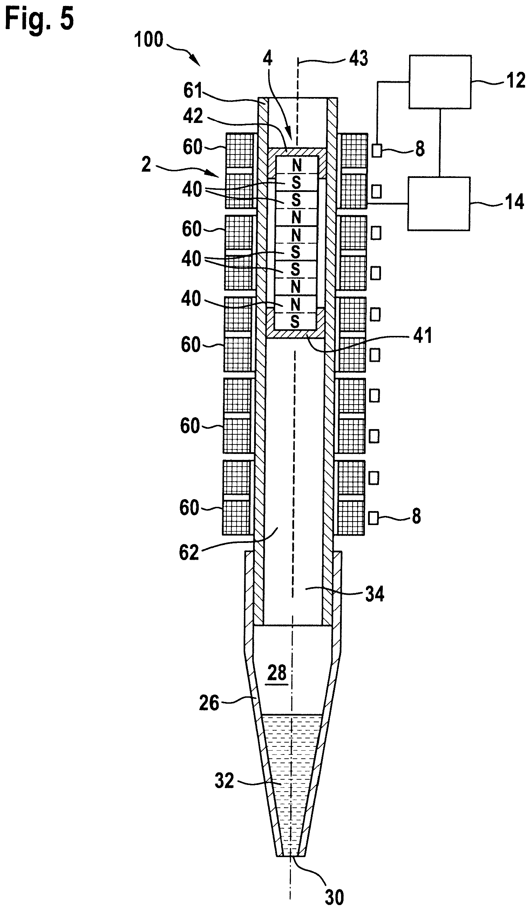

Fig. 5 zeigt ein Pipettiersystem 100 gemäß einer beispielhaften Ausführungsform der Erfindung. Das Pipettiersystem 100 hat einen Elektromotor 2, der von seinem Prinzip her dem Elektromotor 2 der Fig. 1 sehr ähnlich ist. Die analogen Komponenten sind mit den gleichen Bezugszeichen versehen und werden nicht nochmals beschrieben. Auf die Beschreibung der Fig. 1 wird ausdrücklich Bezug genommen. Der Elektromotor 2 ist in dem Pipettiersystem 100 der Fig. 5 vertikal angeordnet.

Der durch den Hohlzylinder 61 gebildete Kanal 62 ist ein Pipettierkanal 62 des Pipettiersystems 100. Der Läufer 4 des Elektromotors 2 ist der Kolben 4 des Pipettiersystems 100, der in dem Pipettierkanal 62 beweglich aufgenommen ist. Die erste Endkappe 41 des Läufers ist die untere Endkappe des Kolbens, die zweite Endkappe 42 des Läufers ist die obere Endkappe der Kolbens. Die erste und zweite Endkappe 41, 42 sind Abdichtungen, die den Kolben gegenüber dem Pipettierkanal 62 abdichten.

Der Läufer 4 hat im vorliegenden Beispiel fünf Permanentmagnete 40, die wie in Fig. 1 paarweise mit aufeinander zuweisenden gleichnamigen Polen angeordnet sind. Im vorliegenden Beispiel sind ferner zehn Hall-Sensoren 8 und zehn Spulen 60 vorhanden. Es ist ersichtlich, dass die Anzahl der Permanentmagnete, die Anzahl der Spulen und die Anzahl der Magnetfeld-Sensoren an die konkrete Ausführungsform anpassbar sind.

Die Endkappen 41, 42 sind bevorzugt aus reibungsarmem, Graphit umfassenden Material gebildet, wie es beispielsweise von kommerziell erhältlichen Kolben der Fa. Airpot Corporation in Norwalk, Connecticut, (US) bekannt ist. Um die von diesem Material bereitgestellte geringe Reibung möglichst vollständig ausschöpfen zu können, ist der Hohlzylinder 61 bevorzugt als Glaszylinder ausgebildet, so dass bei einer Bewegung des Kolbens 4 längs der Bewegungsbahn 43 das Graphit umfassende Material äußerst reibungsarm an einer Glasfläche gleitet.

Wie oben bezüglich der Fig. 1 bis 4 beschrieben, übermitteln die Magnetfeld-Sensoren 8 Messdaten an die Positionsbestimmungseinheit 12, welche wiederum die Position des Kolbens 4 bestimmt und an die Steuereinheit 14 überträgt, welche wiederum auf Grundlage der Position des Kolbens 4 die Spulen 60 ansteuert. Für die Details dieser Regelung wird auf die obige Beschreibung verwiesen.

An dem dosierseitigen Ende des Pipettierkanals ist in an sich bekannter Weise lösbar eine Pipettierspitze 26 angebracht. Die Pipettierspitze 26 definiert einen Pipettierraum 28 in ihrem Inneren, welcher am Pipettierkanal-fernen Ende ausschließlich durch eine Pipettieröffnung 30 zugänglich ist. In dem in Fig. 5 dargestellten beispielhaften Zustand vor einem Dispensionsvorgang ist im Pipettierraum 28 eine Menge an Dosierflüssigkeit 32 vorhanden. Diese ist durch einen zuvor ausgeführten Aspiriationsvorgang aufgenommen worden.

Zwischen dem Läufer 4 und der Dosierflüssigkeit 32 befindet sich dauerhaft Arbeitsgas 34, welches als Kraftvermittler zwischen dem Läufer 4 und der Dosierflüssigkeit 32 dient. Das Arbeitsgas 34 ist auch bei völlig entleerter Pipettierspitze 26 zwischen Läufer 4 und einer Dosierflüssigkeit 32 angeordnet, da die Pipettierspitze 26 zur Aspiration von Dosierflüssigkeit in einen entsprechenden Dosierflüssigkeitsvorrat eingetaucht wird, sodass in diesem Zustand wenigstens an der Pipettieröffnung 30 ein Meniskus der Dosierflüssigkeit vorhanden ist. Somit befindet sich Arbeitsgas 34 in jedem für einen Pipettiervorgang relevanten Zustand dauerhaft vollständig zwischen dem Läufer 4 und einer Dosierflüssigkeit 32 und trennt diese voneinander.

Ausgehend von dem in Fig. 5 gezeigten Zustand werden nachfolgend zwei Arten von Dispensationsvorgängen des Pipettiersystems 100 beschrieben. Zum einen ist es möglich, den Läufer 4 vergleichsweise langsam zu bewegen und durch eine vergleichsweise geringe Erhöhung des Drucks des Arbeitsgases 34 eine entsprechende Menge an Pipettierflüssigkeit 32 durch die Pipettieröffnung 30 herauszudrücken. Zum anderen ist es möglich, den Läufer 4 in einer vergleichsweise schnellen, peitschenartigen Bewegung zu bewegen und mit der resultierenden Druckwelle die gewünschte Menge an Pipettierflüssigkeit 32 durch die Pipettieröffnung 30 herauszudrücken. Bei dieser Ausführungsform kann zur Dispensation einer sehr kleinen Flüssigkeitsmenge, etwa 1 µl der Dosierflüssigkeit 32, eine Bewegung des Läufers 4 veranlasst werden, die einen so großen Hub hat, dass die Endfläche der ersten Endkappe 41 ein Volumen überstreicht, das ein Vielfaches, etwa das 20-fache des Volumens der sehr kleinen Flüssigkeitsmenge ist. Dadurch wird eine Druckwelle aufgebaut. In sehr schneller Abfolge wird der Läufer 4 nach der Bewegung auf die Pipettierflüssigkeit 32 hin zurückgezogen, wobei er dort zum Halt kommt, wo die Änderung seiner Position gegenüber der Ausgangsposition dem Volumen der sehr kleinen Flüssigkeitsmenge entspricht. Durch die Rückbewegung des Läufers 4 wird ein der Druckwelle entgegenwirkender Druckabfall produziert. Die Druckwelle drückt vor ihrem Abklingen die sehr kleine Flüssigkeitsmenge aus der Pipettieröffnung 30.

Für beide beschriebenen Dispensationsvorgänge kann der Läufer geregelt bewegt werden, wie oben mit Bezug auf Fig. 1 bis 4 beschrieben. Besonders bei der zweiten Ausführungsvariante mit der vergleichsweise schnellen Bewegung des Läufers 4 ist das oben beschriebene Verfahren zur Positionsbestimmung sehr gut einsetzbar, weil die Position des Läufers 4 sehr schnell bestimmt werden kann und die Regelung der Position des Läufers 4 der hohen Dynamik der Bewegung des Läufers 4 entsprechen kann. FürAspirationsvorgänge gilt Analoges.

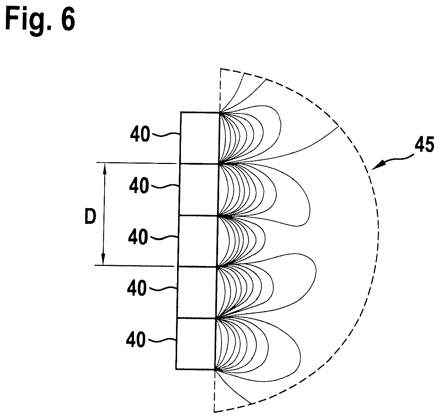

Fig. 6 zeigt eine Mehrzahl von Permanentmagneten 40, wie sie z.B. in dem Läufer 4 des Pipettiersystems 100 der Fig. 5 vorgesehen sein können, sowie einen Teil des Läufermagnetfelds 45. Insbesondere sind in Fig. 6 fünf Permanentmagnete 40 gezeigt, die jeweils mit gegensinnigen Polen zueinander hin angeordnet sind, wie oben bezüglich Fig. 1 und Fig. 5 im Detail beschrieben. Der Abstand D benachbarter gleichartiger Maxima des Läufermagnetfelds entspricht somit der Länge von zwei Permanentmagneten 40.

Von dem Läufermagnetfeld 45 ist ein durch eine gestrichelte Linie begrenzter Teil in Fig. 6 gezeigt. Das Läufermagnetfeld 45 ist durch mehrere Magnetfeldlinien illustriert. Aus der Fig. 6 wird deutlich, dass an den Grenzen zwischen den Permanentmagneten jeweils mehrere Magnetfeldlinien zusammenlaufen, was ein jeweiliges Magnetfeldmaximum anzeigt. An den Grenzen zwischen den Permanentmagneten ergibt sich ein Magnetfeld mit einer starken Feldkomponente, die zu der Ausrichtung der Permanentmagnete orthogonal ist, in einem rotationssymmetrischen System also radial ist. Eine solche starke Magnetfeldkomponente lässt sich gut detektieren.

Es wird betont, dass weder Fig. 6 noch die vorherigen Figuren maßstabsgetreu sind. Sie dienen zur Veranschaulichung des Funktionsprinzips von beispielhaften Ausführungsformen der Erfindung. Es ist ersichtlich, dass zum Beispiel die Stärke des Läufermagnetfelds und der Abstand zwischen den Permanentmagneten und den Magnetfeld-Sensoren für eine besonders effiziente und zuverlässige Positionsbestimmung aufeinander angepasst sein können.

Das Pipettiersystem der Fig. 5 kann jegliche in WO 2017/017084 A1 gezeigten Komponenten und Modifikationen haben. Der Inhalt der genannten Patentanmeldung wird vollumfänglich in die vorliegende Patentanmeldung per Verweis einbezogen.

Das beschriebene Verfahren zur Positionsbestimmung und der beschriebene Elektromotor sind auch für ein Pipettiersystem geeignet, bei dem der Kolben direkt an der Pipettierflüssigkeit anliegt.

Weiterhin sind das beschriebene Verfahren zur Positionsbestimmung und der beschriebene Elektromotor für jegliche andere technische Systeme geeignet, bei denen eine durch einen Elektromotor angetriebene Komponente mit hoher Genauigkeit bewegt wird.

Obwohl die Erfindung mit Bezug auf beispielhafte Ausführungsformen beschrieben worden ist, ist es für einen Fachmann ersichtlich, dass verschiedene Änderungen vorgenommen und Äquivalente verwendet werden können, ohne den Bereich der Erfindung zu verlassen. Die Erfindung soll nicht durch die beschriebenen spezifischen Ausführungsformen beschränkt sein. Vielmehr enthält sie alle Ausführungsformen, die unter die angehängten Patentansprüche fallen.

## Patentansprüche

1. Verfahren zum berührungslosen Bestimmen der Position eines angetriebenen Läufers (4) eines Elektromotors (2) mittels einer Mehrzahl von Magnetfeld-Sensoren (8), wobei der Läufer bezüglich eines Stators (6) beweglich angeordnet ist und eine Mehrzahl von Permanentmagneten (40) aufweist, die ein Läufermagnetfeld mit einer Mehrzahl von periodisch beabstandeten Maxima erzeugen, und wobei die Mehrzahl von Magnetfeld-Sensoren entlang einer Bewegungsbahn (43) des Läufers angeordnet sind,
wobei das Verfahren die folgenden Schritte aufweist:
mittels der Mehrzahl von Magnetfeld-Sensoren, Bestimmen einer Mehrzahl von Messwerten (70) für ein von der Position des Läufers abhängiges, durch die Mehrzahl von Permanentmagneten erzeugtes Momentanmagnetfeld,
Auswählen einer Untermenge (72) der Mehrzahl von Messwerten, wobei die Untermenge (72) der Mehrzahl von Messwerten insbesondere von einander benachbart angeordneten Magnetfeld-Sensoren (8) stammt,
Bestimmen einer spezifischen spektralen Signalkomponente (74) aus der Untermenge (72) der Mehrzahl von Messwerten (70), wobei die spezifische spektrale Signalkomponente diejenige Ortsfrequenz hat, die dem Abstand benachbarter gleichartiger Maxima des Läufermagnetfelds entspricht, und
Bestimmen der Position des angetriebenen Läufers mittels der spezifischen spektralen Signalkomponente, wobei das Bestimmen der Position des angetriebenen Läufers (4) mittels des Phasenwinkels der spezifischen spektralen Signalkomponente (74) durchgeführt wird, wobei das Bestimmen der Position des angetriebenen Läufers (4) ein Umrechnen des Phasenwinkels der spezifischen spektralen Signalkomponente (74) in einen Versatz des angetriebenen Läufers gegenüber einer bekannten Position beinhaltet.

2. Verfahren nach Anspruch 1,
wobei das Bestimmen der spezifischen spektralen Signalkomponente (74) durch ein Anwenden des Görtzel-Algorithmus auf mindestens einen Teil der Mehrzahl von Messwerten (70) durchgeführt wird,
oder
wobei das Bestimmen der spezifischen spektralen Signalkomponente (74) durch ein Anwenden der Fast Fourier Transformation (FFT) auf mindestens einen Teil der Mehrzahl von Messwerten (70) durchgeführt wird.

3. Verfahren nach einem der vorhergehenden Ansprüche, wobei das Auswählen der Untermenge (72) der Mehrzahl von Messwerten die folgenden Schritte aufweist:
Ordnen der Mehrzahl von Messwerten (70) entsprechend der räumlichen Anordnung der Magnetfeld-Sensoren (8) entlang der Bewegungsbahn (43) des Läufers,
Bestimmen des ersten Messwerts, dessen Absolutwert einen vorbestimmten Schwellwert überschreitet, und
Auswählen des genannten ersten Messwerts und benachbarter Messwerte als die genannte Untermenge (72) der Mehrzahl von Messwerten.

4. Verfahren nach einem der vorhergehenden Ansprüche, wobei das Bestimmen der Mehrzahl von Messwerten die folgenden Schritte aufweist:
Erstellen von Messdaten durch die Mehrzahl von Magnetfeld-Sensoren (8), und
Erzeugen der Mehrzahl von Messwerten durch Kalibrieren der Messdaten, wobei das Kalibrieren ein Kompensieren von Antriebs-Magnetfeld-Komponenten aufweist, die im Betrieb von Antriebselementen des Elektromotors, insbesondere von stromdurchflossenen Spulen (60) des Elektromotors, erzeugt werden.

5. Verfahren nach Anspruch 4, wobei das Kalibrieren weiterhin aufweist:
Kompensieren von Offsets der Mehrzahl von Magnetfeld-Sensoren (8), und/ oder
Kompensieren von Produktionsungenauigkeiten, insbesondere Kompensieren von Messfehlern, die durch ungenau positionierte Magnetfeld-Sensoren hervorgerufen sind.

6. Verfahren nach einem der vorhergehenden Ansprüche, wobei die Schritte des Bestimmens der Mehrzahl von Messwerten (70), des Bestimmens der spezifischen spektralen Signalkomponente (74) und des Bestimmens der Position des angetriebenen Läufers (4) bei Bewegung des Läufers wiederholt ausgeführt werden, insbesondere mindestens einmal jede ms ausgeführt werden, weiter insbesondere mindestens einmal jede 100 µs ausgeführt werden.

7. Verfahren zum Bewegen eines angetriebenen Läufers eines Elektromotors (2), aufweisend:
Bestimmen der Position des angetriebenen Läufers (4) gemäß dem Verfahren nach einem der vorhergehenden Ansprüche, und
Bewegen des angetriebenen Läufers auf Basis der bestimmten Position des angetriebenen Läufers.

8. Verfahren nach Anspruch 7, wobei der angetriebene Läufer (4) ein Kolben einer Pipettiervorrichtung (100) ist oder wobei der angetriebene Läufer mit einem Kolben einer Pipettiervorrichtung zum Bewegen des Kolbens gekoppelt ist, und wobei durch ein Bewegen des Kolbens Pipettierflüssigkeit (32) aspiriert bzw. dispensiert wird.

9. Elektromotor (2) mit berührungsloser Positionsbestimmung, aufweisend:
einen angetriebenen Läufer (4) mit einer Mehrzahl von Permanentmagneten (40), die ein Läufermagnetfeld mit einer Mehrzahl von periodisch beabstandeten Maxima erzeugen,
einen Stator (6), wobei der angetriebene Läufer beweglich gegenüber dem Stator angeordnet ist,
eine Mehrzahl von Magnetfeld-Sensoren (8), die entlang einer Bewegungsbahn (43) des Läufers angeordnet sind zum Messen des entlang der Bewegungsbahn vorhandenen Magnetfelds, und
eine Positionsbestimmungseinheit (12), die von der Mehrzahl von Magnetfeld-Sensoren Messdaten empfängt und die eingerichtet ist:
eine Mehrzahl von Messwerten (70) aus den Messdaten zu erstellen, wobei die Mehrzahl von Messwerten (70) Abtastpunkte für ein von der Position des Läufers abhängiges, durch die Mehrzahl von Permanentmagneten erzeugtes Momentanmagnetfeld sind,
eine Untermenge (72) der Mehrzahl von Messwerten auszuwählen, wobei die Untermenge (72) der Mehrzahl von Messwerten insbesondere von einander benachbart angeordneten Magnetfeld-Sensoren (8) stammt,
eine spezifische spektrale Signalkomponente (74) aus der Untermenge der Mehrzahl von Messwerten (70) zu bestimmen, wobei die spezifische spektrale Signalkomponente diejenige Ortsfrequenz hat, die dem Abstand benachbarter gleichartiger Maxima des Läufermagnetfelds entspricht, und
die Position des angetriebenen Läufers auf Basis der spezifischen spektralen Signalkomponente mittels des Phasenwinkels der spezifischen spektralen Signalkomponente (74) zu bestimmen, wobei die Positionsbestimmungseinheit (12) eingerichtet ist, den Phasenwinkel der spezifischen spektralen Signalkomponente (74) in einen Versatz des angetriebenen Läufers (4) gegenüber einer bekannten Position umzurechnen.

10. Elektromotor (2) nach Anspruch 9, wobei der Abstand benachbarter gleichartiger Maxima des Läufermagnetfelds zwischen 10 mm und 20 mm, insbesondere zwischen 12 mm und 15 mm, weiter insbesondere zwischen 13 mm und 14 mm, beträgt.

11. Elektromotor (2) nach einem der Ansprüche 9 bis 10,
wobei die Positionsbestimmungseinheit (12) eingerichtet ist, die spezifische spektrale Signalkomponente (74) durch ein Anwenden des Görtzel-Algorithmus auf mindestens einen Teil der Mehrzahl von Messwerten (70) zu bestimmen,
oder
wobei die Positionsbestimmungseinheit (12) eingerichtet ist, die spezifische spektrale Signalkomponente (74) durch ein Anwendender Fast Fourier Transformation (FFT) auf mindestens einen Teil der Mehrzahl von Messwerten (70) zu bestimmen.

12. Elektromotor (2) nach einem der Ansprüche 9 bis 11, wobei der Stator (86) eine Mehrzahl von Spulen (60) aufweist, die entlang der Bewegungsbahn (43) des Läufers (4) angeordnet sind, wobei der angetriebene Läufer durch ein gesteuertes Anlegen von Strom an die Mehrzahl von Spulen bewegbar ist, wobei der Elektromotor insbesondere weiterhin eine Steuereinheit (14) aufweist, die mit der Positionsbestimmungseinheit (12) gekoppelt ist und eingerichtet ist, den Stromfluss durch die Mehrzahl von Spulen (60) auf Basis der bestimmten Position des angetriebenen Läufers (4) zu steuern.

13. Pipettiersystem (100) zum Aspirieren und Dispensieren von Pipettierflüssigkeit (32), aufweisend:
einen Kolben, der ein flüssigkeitszugewandtes Ende und ein flüssigkeitsabgewandtes Ende hat,
einen Pipettierkanal, in dem der Kolben angeordnet ist und an dessen Ende eine Pipettierspitze (26) angeordnet ist, wobei durch Bewegen des Kolbens ein Aspirieren bzw. Dispensieren von Pipettierflüssigkeit (32) durch die Pipettierspitze möglich ist, und
einen Elektromotor (2) nach einem der Ansprüche 9 bis 12, wobei der angetriebene Läufer (4) Teil des Kolbens ist oder wobei der angetriebene Läufer mit dem Kolben antriebsmäßig gekoppelt ist.

14. Computerprogramm, welches Programmanweisungen enthält, die bei Ausführung auf einer Datenverarbeitungsanlage ein Verfahren nach einem der Ansprüche 1 bis 8 auf einer Vorrichtung nach einem der Ansprüche 9 bis 13 durchführen.

## Claims

1. A method for contactless determination of the position of a driven moving portion (4) of an electric motor (2) by means of a plurality of magnetic field sensors (8), wherein the moving portion is movably arranged with respect to a stator (6) and has a plurality of permanent magnets (40) which generate a moving-portion magnetic field having a plurality of periodically spaced apart maxima, and wherein the plurality of magnetic field sensors are arranged along a movement path (43) of the moving portion,
the method comprising the following steps:
by means of the plurality of magnetic field sensors, determining a plurality of measured values (70) for a momentary magnetic field that is generated by the plurality of permanent magnets and dependent on the position of the moving portion,
selecting a subset (72) of the plurality of measured values, said subset (72) of the plurality of measured values being taken in particular from magnetic field sensors (8) arranged adjacent each other,
determining a specific spectral signal component (74) from the plurality of measured values (70), the specific spectral signal component having the spatial frequency corresponding to the distance between adjacent like maxima of the moving-portion magnetic field, and
determining the position of the driven moving portion by means of the specific spectral signal component, wherein said determining of the position of the driven moving portion (4) is performed by means of the phase angle of the specific spectral signal component (74), wherein said determining of the position of the driven moving portion (4) comprises converting the phase angle of the specific spectral signal component (74) into an offset of the driven moving portion with respect to a known position.

2. The method according to claim 1,
wherein said determining of the specific spectral signal component (74) is performed by applying the Goertzel algorithm to at least part of the plurality of measured values (70),
or
wherein said determining of the specific spectral signal component (74) is performed by applying the Fast Fourier Transform (FFT) to at least part of the plurality of measured values (70).

3. The method according to any of the preceding claims,
wherein said selecting of the subset (72) of the plurality of measured values comprises the following steps:
organizing the plurality of measured values (70) in accordance with the spatial arrangement of the magnetic field sensors (8) along the movement path (43) of the moving portion,
determining the first measured value whose absolute value exceeds a predetermined threshold value, and
selecting said first measured value and adjacent measured values as said subset (72) of the plurality of measured values.

4. The method according to any of the preceding claims,
wherein said determining of the plurality of measured values comprises the following steps:
providing measured data by the plurality of magnetic field sensors (8), and
generating the plurality of measured values by calibrating the measured data, wherein said calibrating comprises compensating for drive magnetic-field components, which are generated during operation by drive elements of the electric motor, in particular current-carrying coils (60), of the electric motor.

5. The method according to claim 4,
wherein said calibrating further comprises:
compensating for offsets of the plurality of magnetic field sensors (8),
and/or
compensating for production inaccuracies, in particular compensating for measurement errors caused by inaccurately positioned magnetic field sensors.

6. The method according to any of the preceding claims,
wherein the steps of determining the plurality of measured values (70), determining the specific spectral signal component (74) and determining the position of the driven moving portion (4) are carried out repeatedly during movement of the moving portion, in particular are carried out at least once every ms, still more in particular are carried out at least once every 100 µs.

7. A method of moving a driven moving portion of an electric motor (2), comprising:
determining the position of the driven moving portion (4) in accordance with the method of any of the preceding claims, and
moving the driven moving portion on the basis of the determined position of the driven moving portion.

8. The method according to claim 7,
wherein the driven moving portion (4) is a piston of a pipetting device (100) or wherein the driven moving portion is coupled to a piston of a pipetting device for moving the piston, and wherein pipetting liquid (32) is aspirated or dispensed by movement of the piston.

9. An electric motor (2) with contactless position determination, comprising:
a driven moving portion (4) having a plurality of permanent magnets (40) which generate a moving-portion magnetic field having a plurality of periodically spaced apart maxima,
a stator (6), with said driven moving portion being arranged so as to be movable with respect the stator,
a plurality of magnetic field sensors (8) which are arranged along a movement path (43) of the moving portion for measuring the magnetic field present along the movement path, and
a position determination unit (12) which receives measured data from the plurality of magnetic field sensors and is configured to:
provide a plurality of measured values (70) from the measured data, the plurality of measured values (70) being sampling points for a momentary magnetic field that is generated by the plurality of permanent magnets and dependent on the position of the moving portion,
select a subset (72) of the plurality of measured values, said subset (72) of the plurality of measured values being taken in particular from magnetic field sensors (8) arranged adjacent each other,
determine a specific spectral signal component (74) from the plurality of measured values (70), said specific spectral signal component having the spatial frequency corresponding to the distance between adjacent like maxima of the moving-portion magnetic field and
determine the position of the driven moving portion on the basis of the specific spectral signal component by means of the phase angle of the specific spectral signal component (74), wherein the position determination unit (12) is configured to convert the phase angle of the specific spectral signal component (74) into an offset of the driven moving portion (4) with respect to a known position.

10. The electric motor (2) according to claim 9,
wherein the distance between adjacent like maxima of the moving-portion magnetic field is between 10 mm and 20 mm, in particular between 12 mm and 15 mm, still more in particular between 13 mm and 14 mm.

11. The electric motor (2) according to any of claims 9 to 10,
wherein the position determination unit (12) is configured to determine the specific spectral signal component (74) by applying the Goertzel algorithm to at least part of the plurality of measured values (70),
or
wherein the position determination unit (12) is configured to determine the specific spectral signal component (74) by applying the Fast Fourier Transform (FFT) to at least part of the plurality of measured values (70).

12. The electric motor (2) according to any of claims 9 to 11,
wherein the stator (86) comprises a plurality of coils (60) disposed along the movement path (43) of the moving portion (4), with the driven moving portion being movable by controlled supply of current to the plurality of coils, wherein the electric motor in particular further comprises a control unit (14) coupled to the position determination unit (12) and configured to adjust the current flow through the plurality of coils (60) on the basis of the determined position of the driven moving portion (4).

13. A pipetting system (100) for aspirating and dispensing pipetting liquid (32), comprising:
a piston having a liquid-facing end and a liquid-remote end,
a pipetting channel in which the piston is disposed and at the end of which a pipetting tip (26) is arranged, wherein, by moving the piston, aspirating and dispensing of pipetting liquid (32) through the pipetting tip is possible, and
an electric motor (2) according to any of claims 9 to 12, wherein the driven moving portion (4) is part of the piston or wherein the driven moving portion is drivingly coupled to the piston.

14. A computer program comprising program instructions which, when executed on a data processing system, perform a method according to any of claims 1 to 8 on a device according to any of claims 9 to 13.

## Revendications

1. Procédé destiné à la détermination sans contact de la position d'un mobile entraîné (4) d'un moteur électrique (2) au moyen d'une multitude de capteurs de champs magnétiques (8) ; dans lequel le mobile est disposé en mobilité par rapport à un stator (6) et présente une multitude d'aimants permanents (40) qui génèrent un champ magnétique de mobile avec une multitude de maxima espacés de manière périodique ; et dans lequel la multitude de capteurs de champs magnétiques sont disposés le long d'une trajectoire de mouvement (43) du mobile ;
dans lequel le procédé présente les étapes suivantes dans lesquelles :
au moyen de la multitude des capteurs de champs magnétiques, on détermine une multitude de valeurs de mesure (70) pour un champ magnétique momentané qui dépend de la position du mobile, généré par la multitude d'aimants permanents ;
on sélectionne un sous-ensemble (72) de la multitude de valeurs de mesure ; dans lequel le sous-ensemble (72) de la multitude de valeurs de mesure émane en particulier de capteurs de champs magnétiques (8) qui sont disposés dans des positions respectivement adjacentes ;
on détermine une composante de signal spectrale spécifique (74) à partir du sous-ensemble (72) de la multitude de valeurs de mesure (70) ; dans lequel la composante de signal spectrale spécifique possède la fréquence spatiale qui correspond à la distance entre des maxima voisins de même type du champ magnétique du mobile ; et on détermine la position du mobile entraîné au moyen de la composante de signal spectrale spécifique ; dans lequel la détermination de la position du mobile entraîné (4) est mise en oeuvre au moyen de l'angle de phase de la composante de signal spectrale spécifique (74) ; dans lequel la détermination de la position du mobile entraîné (4) englobe une conversion de l'angle de phase de la composante de signal spectrale spécifique (74) en un décalage du mobile entraîné par rapport à une position connue.

2. Procédé selon la revendication 1, dans lequel la détermination de la composante de signal spectrale spécifique (74) est mise en oeuvre par l'intermédiaire d'une application de l'algorithme de Görtzel à au moins une partie de la multitude de valeurs de mesure (70) ; ou dans lequel la détermination de la composante de signal spectrale spécifique (74) est mise en oeuvre par l'intermédiaire d'une application de la transformation de Fourier rapide (FFT) à au moins une partie de la multitude de valeurs de mesure (70).

3. Procédé selon l'une quelconque des revendications précédentes, dans lequel la sélection du sous-ensemble (72) de la multitude de valeurs de mesure présente les étapes suivantes dans lesquelles :
on ordonne la multitude de valeurs de mesure (70) de manière correspondante à l'agencement spatial des capteurs de champs magnétiques (8) le long de la trajectoire de mouvement (43) du mobile ;
on détermine la première valeur de mesure, dont la valeur absolue dépasse vers le haut une valeur seuil qui a été déterminée au préalable ; et
on sélectionne la première valeur de mesure mentionnée et les valeurs de mesure voisines comme étant le sous-ensemble mentionné (72) de la multitude de valeurs de mesure.

4. Procédé selon l'une quelconque des revendications précédentes, dans lequel la détermination de la multitude de valeurs de mesure présente les étapes suivantes dans lesquelles ;
on élabore des données de mesure par l'intermédiaire de la multitude de capteurs de champs magnétiques (8) ; et
on génère la multitude de valeurs de mesure l'intermédiaire d'un étalonnage des données de mesure ; dans lequel l'étalonnage présente une compensation des composants d'entraînement de champs magnétiques, qui sont générés lors de la mise en service d'éléments d'entraînement du moteur électrique, en particulier de bobines (60) traversées par le courant, du moteur électrique.

5. Procédé selon la revendication 4, dans lequel l'étalonnage présente en outre le fait de :
compenser des décalages de la multitude de capteurs de champs magnétiques (8) ; et/ou
compenser des imprécisions de production, en particulier compenser des erreurs de mesure qui sont dues à des capteurs de champs magnétiques positionnés de manière imprécise.

6. Procédé selon l'une quelconque des revendications précédentes, dans lequel les étapes de la détermination de la multitude de valeurs de mesure (70), de la détermination de la composante de signal spectrale spécifique (74) et de la détermination de la position du mobile entraîné (4) sont mises en oeuvre de manière répétée lorsque le mobile est mis en mouvement, en particulier sont mises en oeuvre au moins une fois par milliseconde, de manière plus particulière sont mises en oeuvre au moins une fois toutes les 100 microsecondes.

7. Procédé destiné à la mise en mouvement d'un mobile entraîné d'un moteur électrique (2), qui présente :
la détermination de la position du mobile entraîné (4) conformément au procédé selon l'une quelconque des revendications précédentes ; et
la mise en mouvement du mobile entraîné sur base de la position déterminée du mobile entraîné.

8. Procédé selon la revendication 7, dans lequel le mobile entraîné (4) représente un piston d'un dispositif de pipetage (100) ; ou dans lequel le mobile entraîné est couplé à un piston d'un dispositif de pipetage pour la mise en mouvement du piston ; et dans lequel, par l'intermédiaire d'une mise en mouvement du piston, on aspire, respectivement on distribue un liquide de pipetage (32).

9. Moteur électrique (2) comportant une détermination de la position sans contact, qui présente :
un mobile entraîné (4) qui comprend une multitude d'aimants permanents (40) qui génèrent un champ magnétique de mobile avec une multitude de maxima espacés de manière périodique ;
un stator (6) ; dans lequel le mobile entraîné est disposé en mobilité par rapport au stator ;
une multitude de capteurs de champs magnétiques (8) qui sont disposés le long d'une trajectoire de mouvement (43) du mobile, destinés à la mesure des champs magnétiques qui sont présents le long de la trajectoire de mouvement ; et
une unité de détermination de la position (12) qui reçoit les données de mesure de la part de la multitude de capteurs de champs magnétiques et qui est conçue :
pour établir une multitude de valeurs de mesure (70) à partir des données de mesure ; dans lequel la multitude de valeurs de mesure (70) représente des points de balayage pour un champ magnétique momentané qui dépend de la position du mobile, généré par la multitude d'aimants permanents ;
pour sélectionner un sous-ensemble (72) de la multitude de valeurs de mesure ; dans lequel le sous-ensemble (72) de la multitude de valeurs de mesure émane en particulier de capteurs de champs magnétiques (8) qui sont disposés dans des positions respectivement adjacentes ;
pour déterminer une composante de signal spectrale spécifique (74) à partir du sous-ensemble de la multitude de valeurs de mesure (70) ; dans lequel la composante de signal spectrale spécifique possède la fréquence spatiale qui correspond à la distance entre des maxima voisins de même type du champ magnétique du mobile ; et
pour déterminer la position du mobile entraîné sur base de la composante de signal spectrale spécifique au moyen de l'angle de phase de la composante de signal spectrale spécifique (74) ; dans lequel l'unité de la détermination de la position (12) est conçue pour convertir l'angle de phase de la composante de signal spectrale spécifique en un décalage du mobile entraîné (4) par rapport à une position connue.

10. Moteur électrique (2) selon la revendication 9, dans lequel la distance entre des maxima voisins de même type du champ magnétique de mobile se situe entre 10 mm et 20 mm, en particulier entre 12 mm et 15 mm, de manière plus particulière entre 13 mm et 14 mm.

11. Moteur électrique (2) selon l'une quelconque des revendications 9 à 10,
dans lequel l'unité de détermination de la position (12) est conçue pour déterminer la composante de signal spectrale spécifique (74) par l'intermédiaire d'une application de l'algorithme de Görtzel à au moins une partie de la multitude de valeurs de mesure (70) ;
ou
dans lequel l'unité de détermination de la position (12) est conçue pour déterminer la composante de signal spectrale spécifique (74) par l'intermédiaire d'une application de la transformation de Fourier rapide (FFT) à au moins une partie de la multitude de valeurs de mesure (70).

12. Moteur électrique (2) selon l'une quelconque des revendications 9 à 11, dans lequel le stator (86) présente une multitude de bobines (60) qui sont disposées le long de la trajectoire de mouvement (43) du mobile (4) ; dans lequel le mobile entraîné peut être mis en mouvement par l'intermédiaire d'une application commandée de courant à la multitude de bobines ; dans lequel le moteur électrique présente en particulier en outre une unité de commande (14) qui est couplée à l'unité de détermination de la position (12) et qui est conçue pour commander le flux de courant à travers la multitude de bobines (60) sur la base de la position déterminée du mobile entraîné (4).

13. Système de pipetage (100) destiné à l'aspiration et à la distribution d'un liquide pipetage (32), qui présente :
un piston qui possède une extrémité tournée vers le liquide et une extrémité qui se détourne du liquide ;
un canal de pipetage dans lequel est disposé le piston et à l'extrémité duquel est disposée une pointe de pipetage (26) ; dans lequel, par l'intermédiaire de la mise en mouvement du piston, on rend possible une aspiration, respectivement une distribution d'un liquide pipetage (32) à travers la pointe de pipetage ; et
un moteur électrique (2) selon l'une quelconque des revendications 9 à 12 ; dans lequel le mobile entraîné (4) fait partie du piston ou dans lequel le mobile entraîné est couplé en entraînement au piston.

14. Programme informatique qui contient des indications de programme qui, par leur application à une installation de traitement de données, mettent en oeuvre un procédé selon l'une quelconque des revendications 1 à 8, sur un dispositif selon l'une quelconque des revendications 9 à 13.
